# EUROPEAN PATENT APPLICATION

(11) **EP 4 775 306 A1**
(43) Date of publication of application: **15.07.2026**
(21) Application number: 25227642.3
(22) Date of filing: 30.12.2025
(51) Int. Cl.: B01J 31/22, B01J 31/24, C08G 61/08, C08L 23/00

(54) **CYCLOOLEFIN RESIN COMPOSITION, RESIN MATERIAL, PREPARATION METHOD THEREFOR, AND USE THEREOF**

(30) Priority: 31.12.2024 CN 202411987665
(71) Applicant: Shanghai Sinochem Science & Technology Co., Ltd, Shanghai 201315 (CN)
(72) Inventor: YANG, Xianfeng, Shanghai, 201315 (CN); TONG, Tao, Shanghai, 201315 (CN); FANG, Jiaxing, Shanghai, 201315 (CN); MI, Yingying, Shanghai, 201315 (CN)
(74) Representative: Michalski Hüttermann & Partner mbB

(57) **Abstract**

The present disclosure discloses a cycloolefin resin composition, a resin material, a preparation method therefor, and a use thereof. Specifically, the present disclosure discloses a use of a cycloolefin resin composition M1 in the preparation of a substrate material for a high-frequency and high-speed information transmission device, wherein the cycloolefin resin composition M1 comprises component A and component B, wherein the component A is cycloolefin, the component B is a ruthenium alkylidene compound of Formula I and/or Formula II or a salt thereof, and the molar ratio of Ru in the component B to the monomer of cycloolefin in the component A is 1:(7500-60000). The resin material prepared using the cycloolefin resin composition of the present disclosure exhibits low dielectric loss and low dielectric constant under high-frequency conditions, along with good heat resistance.

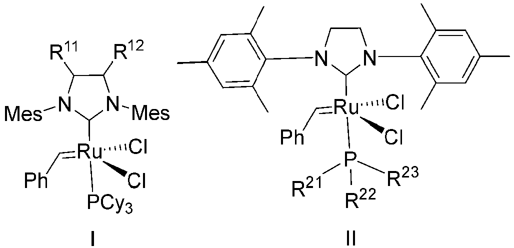

## Description

### CROSS-REFERENCE TO RELATED APPLICATION

The present application claims the right of the priorities of Chinese patent application 202411987665.6 filed on December 31, 2024. The contents of the above Chinese patent application is incorporated herein by reference in their entireties.

### TECHNICAL FIELD

A cycloolefin resin composition, a resin material, a preparation method therefor, and a use thereof.

### BACKGROUND

Currently, technologies in the fields of AI and 5G high-frequency communication are rapidly advancing, with numerous new applications and demands continuously emerging, leading to an expanding market scale. Benefiting from the rapid development of high-frequency and high-speed information transmission technologies, communication products are increasingly achieving higher speeds and multifunctionality in information processing, significantly enhancing information processing efficiency. The development of high-frequency and high-speed information transmission technologies requires new materials in this field to possess lower dielectric constant, lower dielectric loss, and excellent heat resistance in high-frequency environments. Therefore, the development of polymer materials with low dielectric constant, low dielectric loss characteristics, and excellent heat resistance has become an important hot topic in the field of materials research in recent years.

Currently, a new generation of high-performance base materials represented by hydrocarbon resins, which contain only C and H elements in their polymer structures, are rapidly developing in the field of high-frequency and high-speed information transmission. Compared to traditional materials, these materials exhibit excellent properties of low dielectric constant (Dₖ) and low dielectric loss (D_{f}) in high-frequency application scenarios (frequency ≥ 1 GHz) (Dₖ < 3.0, D_{f} < 0.003), and the processability of these materials is significantly superior to that of fluororesins (such as PTFE and PVDF).

With the development of related fields, higher requirements have been proposed for the new generation of substrate materials for high-frequency and high-speed information transmission: under high-frequency conditions (frequency ≥ 1 GHz), the dielectric properties of the materials satisfy Dₖ < 2.6 and D_{f} < 0.001, and considering the use environment of the material, the heat deflection temperature of the relevant materials is required to be no less than 105°C. This criterion poses significant challenges to currently common materials.

CN113736211B and CN112646322B disclose a polydicyclopentadiene/epoxy resin composite for the field of high-frequency copper-clad laminates. The composite material prepared by this technical solution has a dielectric constant Dₖ > 2.5 and a dielectric loss D_{f} > 0.01 under 1 GHz conditions. This technical solution can no longer meet the performance requirements of the current high-frequency information transmission field.

CN111969319A discloses a polydicyclopentadiene material prepared using a two-component resin system, which serves as a low-dielectric and low-loss material for radio wave signal transmission equipment in the 5G field. However, the polydicyclopentadiene prepared by the disclosed technical solution exhibits a dielectric constant Dₖ of up to 2.78 and a dielectric loss D_{f} of 2.1 × 10⁻³ at a test frequency of 1 MHz. The dielectric properties of the polydicyclopentadiene material prepared by this technical solution are entirely inadequate to meet the performance requirements of materials in current high-frequency application fields above 1 GHz.

CN117734286B discloses a high-temperature-resistant, low-dielectric hydrocarbon resin for copper-clad laminate field and a preparation method therefor. The material prepared by this technical solution has a dielectric constant Dₖ > 2.8, and its performance fails to meet the requirements of high-performance high-frequency applications.

CN117756971A discloses a preparation method for a low-dielectric hydrocarbon resin using divinylbenzene as a monomer. The dielectric loss D_{f} of the polymer obtained by this technical solution ranges from 0.003 to 0.0045, which does not fully satisfy the current demands of the high-frequency communication field.

CN111138755A states in the specification that polypropylene material, as a typical low-dielectric material, has a dielectric constant Dₖ between 2.0 and 2.6 and a dielectric loss D_{f} of 0.001 (60 Hz). Since the dielectric loss of the material increases rapidly in high-frequency environments (1 GHz or above), this performance indicator can no longer meet the application requirements of high-performance high-frequency materials.

It can be seen that the high-frequency information transmission materials reported in the prior art have the following defects:
(1) The dielectric properties of the composites obtained by blending epoxy and cycloolefin resins, especially the dielectric loss under high-frequency conditions, are excessively high;
(2) The high-frequency dielectric loss index of conventionally prepared polydicyclopentadiene materials remains relatively high;
(3) The dielectric properties of low-dielectric hydrocarbon resins are still slightly higher than the preferred values in testing environments at 1 GHz and above;
(4) Polypropylene materials exhibit relatively high high-frequency dielectric loss and low heat deflection temperature under unmodified conditions.

### BRIEF SUMMARY OF THE INVENTION

The technical problem to be solved by the present disclosure is to provide a cycloolefin resin composition, a use thereof, and a preparation method for a cycloolefin resin material, addressing the defects of high dielectric constant, large dielectric loss, and poor heat resistance of high-frequency information transmission materials reported in the prior art under high-frequency conditions. The resin material prepared using the cycloolefin resin composition of the present disclosure exhibits low dielectric loss (D_{f} < 0.001) and low dielectric constant (Dₖ < 2.5) under high-frequency conditions (frequency ≥ 1 GHz), along with good heat resistance.

The present disclosure solves the above technical problem through the following technical solutions.

The present disclosure provides a use of a cycloolefin resin composition M1 in the preparation of a substrate material for a high-frequency and high-speed information transmission device, wherein the cycloolefin resin composition M1 comprises component A and component B, wherein the component A is cycloolefin, the component B is a ruthenium alkylidene compound of Formula I and/or Formula II or a salt thereof, and the molar ratio of Ru in the component B to the monomer of cycloolefin in the component A is 1:(7500-60000), 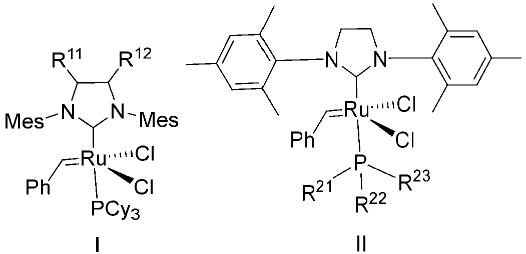 wherein
R¹¹ and R¹² are each independently C₄-C₁₈ alkyl or C₄-C₁₈ alkyl substituted by R¹⁻¹;
R¹⁻¹ is C₆-C₁₀ aryl;
R²¹, R²², and R²³ are each independently C₆-C₁₈ alkyl.

In one embodiment of the present disclosure, the substrate material for the high-frequency and high-speed information transmission device has a dielectric loss of < 0.001 at a frequency of ≥ 1 GHz (e.g., 1-12 GHz, further e.g., 10 GHz), for example, a dielectric loss of 0.00067, 0.00069, 0.00071, 0.00072, 0.00073, 0.00075, 0.00077, 0.00078, 0.00079, 0.00085, 0.00086, 0.00087, 0.00088, 0.00089, 0.0009, or 0.00091.

In one embodiment of the present disclosure, the substrate material for the high-frequency and high-speed information transmission device has a dielectric constant of < 2.5 at a frequency of ≥ 1 GHz (e.g., 1-12 GHz, further e.g., 10 GHz), for example, a dielectric constant of 2.23, 2.26, 2.27, 2.28, 2.29, 2.30, 2.31, or 2.32.

In one embodiment of the present disclosure, the substrate material for the high-frequency and high-speed information transmission device has a glass transition temperature of ≥ 135°C, for example, 138°C, 149°C, 152°C, 155°C, 157°C, 160°C, 162°C, 164°C, 165°C, 166°C, 175°C, 177°C, 186°C, 189°C, or 190°C.

In one embodiment of the present disclosure, the substrate material for the high-frequency and high-speed information transmission device has a heat deflection temperature of ≥ 110°C, for example, 115°C, 117°C, 119°C, 122°C, 126°C, 127°C, 134°C, 137°C, 142°C, 144°C, 147°C, 158°C, or 167°C.

In one embodiment of the present disclosure, the molar ratio of Ru in the component B to the monomer of cycloolefin in the component A is 1:(7500-50000), for example, 1:7500, 1:9500, 1:10000, 1:15000, or 1:50000.

In one embodiment of the present disclosure, in the cycloolefin resin composition M1, the mass percentage of the component A is 80% or more, but less than 100%.

In one embodiment of the present disclosure, the component A is a single type of cycloolefin or a mixture of multiple cycloolefins; the cycloolefin contains only C and H elements and may be substituted by one or more R^{A}, wherein each R^{A} is independently F, C₁-C₁₈ alkyl, C₂-C₁₈ alkenyl, C₆-C₁₀ aryl, alkoxy with a carbon chain length of C₂-C₁₈, -C(=O)OC₂-C₁₈, or -OC(=O)C₂-C₁₈.

In one embodiment of the present disclosure, the component A is a single type of cycloolefin or a mixture of multiple cycloolefins, the component A at least comprises cycloolefin S1, the cycloolefin S1 contains only C and H elements and comprises the following structural moieties: 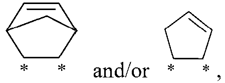 wherein the structural moieties are connected to other parts of the molecule via a carbon atom marked with "*"; the cycloolefin S1 may be substituted by one or more R^{A}, wherein each R^{A} is independently F, C₁-C₁₈ alkyl, C₂-C₁₈ alkenyl, C₆-C₁₀ aryl, C₂-C₁₈ alkoxy, -C(=O)OC₂-C₁₈, or -OC(=O)C₂-C₁₈. It can be understood that when the component A is a single type of cycloolefin, the cycloolefin is the cycloolefin S1.

In one embodiment of the present disclosure, the component A is one or more selected from tetracyclododecene, cyclopentadiene polymer, 5-ethylidene-2-norbornene, cyclohexene, cycloheptene, cyclooctene, and cycloolefin having a structure of Formula A-1 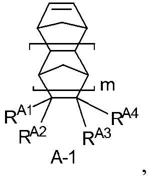 wherein in Formula A-1, m is 0, 1, or 2, and R^{A1}, R^{A2}, R^{A3}, and R^{A4} are each independently H, F, C₁-C₁₈ alkyl, C₂-C₁₈ alkenyl, C₆-C₁₀ aryl, C₂-C₁₈ alkoxy, -C(=O)OC₂-C₁₈, or -OC(=O)C₂-C₁₈; the cyclopentadiene polymer is, for example, one or more selected from dicyclopentadiene, tricyclopentadiene, tetracyclopentadiene, and dihydrodicyclopentadiene; the dihydrodicyclopentadiene is, for example,

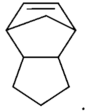

In one embodiment of the present disclosure, the component A is tetracyclododecene.

In one embodiment of the present disclosure, the component A is dihydrodicyclopentadiene.

In one embodiment of the present disclosure, in the component A, the mass percentage of dicyclopentadiene is 70% to 100%, for example, 79%, 80%, 90%, or 98%.

In one embodiment of the present disclosure, in the component A, the mass percentage of tricyclopentadiene is 0% to 30%, for example, 10%, 15%, or 20%.

In one embodiment of the present disclosure, the component A comprises 70% to 100% by mass of dicyclopentadiene and 0% to 30% by mass of tricyclopentadiene.

In one embodiment of the present disclosure, the component A consists of the following components: 85% to 95% by mass of dicyclopentadiene and 5% to 15% by mass of tricyclopentadiene.

In one embodiment of the present disclosure, the component A consists of the following components: 90% to 100% by mass of dicyclopentadiene and 0% to 10% by mass of 5-ethylidene-2-norbornene.

In one embodiment of the present disclosure, the component A consists of the following components: 70% to 90% by mass of dicyclopentadiene, 10% to 30% by mass of tricyclopentadiene, and 0% to 5% by mass of tetracyclopentadiene.

In one embodiment of the present disclosure, the component A consists of the following components: 70% to 90% by mass of dicyclopentadiene, 10% to 20% by mass of tricyclopentadiene, 0% to 10% by mass of dihydrodicyclopentadiene, and 0% to 5% by mass of cyclohexene.

In one embodiment of the present disclosure, the component A is any one of the following schemes:
Scheme 1: the component A consists of 90% by mass of dicyclopentadiene and 10% by mass of tricyclopentadiene;
Scheme 2: the component A consists of 98% by mass of dicyclopentadiene and 2% by mass of 5-ethylidene-2-norbornene;
Scheme 3: the component A consists of 79% by mass of dicyclopentadiene, 20% by mass of tricyclopentadiene, and 1% by mass of tetracyclopentadiene;
Scheme 4: the component A consists of 80% by mass of dicyclopentadiene, 15% by mass of tricyclopentadiene, 4.5% by mass of dihydrodicyclopentadiene, and 0.5% by mass of cyclohexene.

In one embodiment of the present disclosure, in the ruthenium alkylidene compound of Formula I, in R¹¹ and R¹², the C₄-C₁₈ alkyl and the C₄-C₁₈ alkyl in the C₄-C₁₈ alkyl substituted by R¹⁻¹ are each independently C₄-C₁₈ linear alkyl, for example, -(CH₂)₃CH₃, -(CH₂)₅CH₃, -(CH₂)₉CH₃, -(CH₂)₁₃CH₃, or -(CH₂)₁₇CH₃.

In one embodiment of the present disclosure, in the ruthenium alkylidene compound of Formula I, in R¹⁻¹, the C₆-C₁₀ aryl is phenyl or naphthyl, for example, phenyl.

In one embodiment of the present disclosure, in the ruthenium alkylidene compound of Formula I, R¹¹ and R¹² are each independently C₄-C₁₈ alkyl or C₄-C₁₈ alkyl substituted by one phenyl group.

In one embodiment of the present disclosure, the ruthenium alkylidene compound of Formula I is one or more selected from the following compounds: 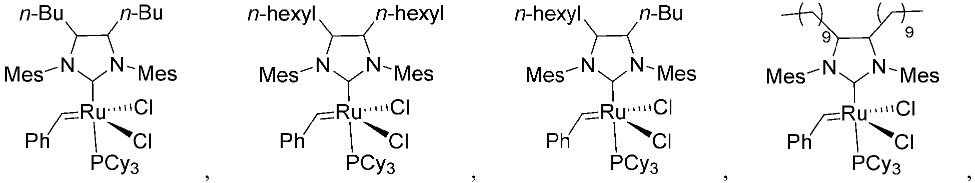 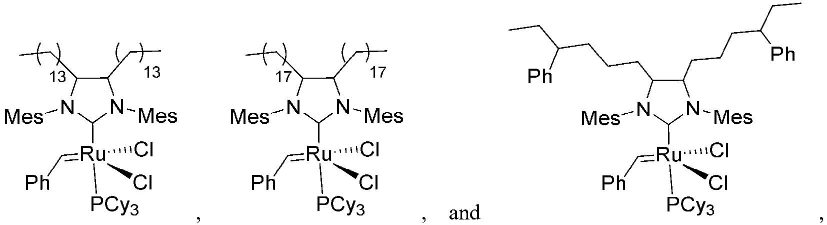 for example,

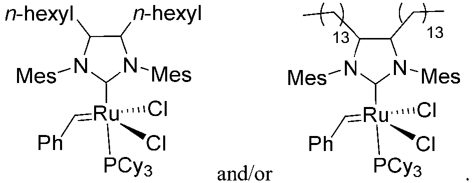

In one embodiment of the present disclosure, in the ruthenium alkylidene compound of Formula II, in R²¹, R²², and R²³, each C₆-C₁₈ alkyl is independently C₆-C₁₀ alkyl, preferably C₆ alkyl, C₈ alkyl, or C₁₀ alkyl.

In one embodiment of the present disclosure, the ruthenium alkylidene compound of Formula II is one or more selected from the following compounds: 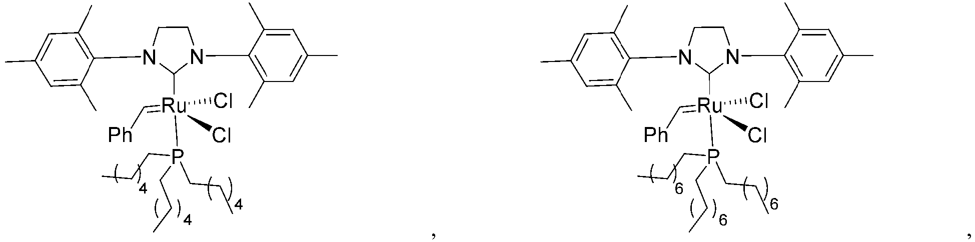 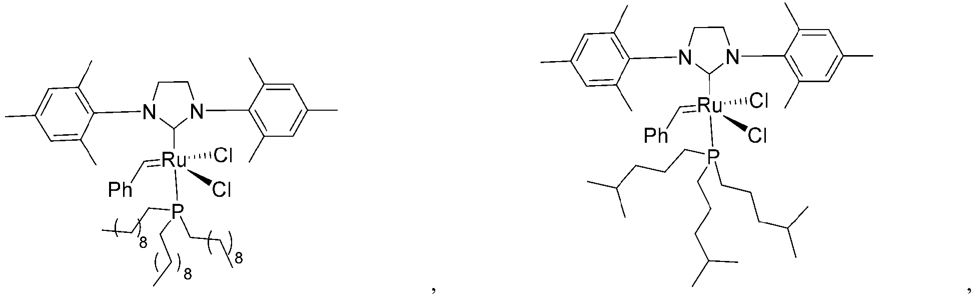 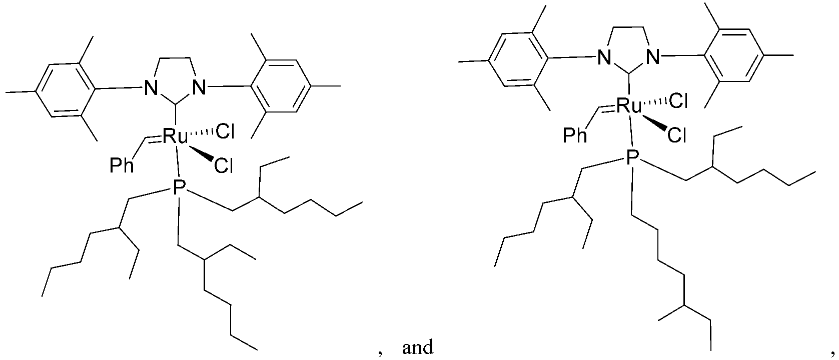 for example,

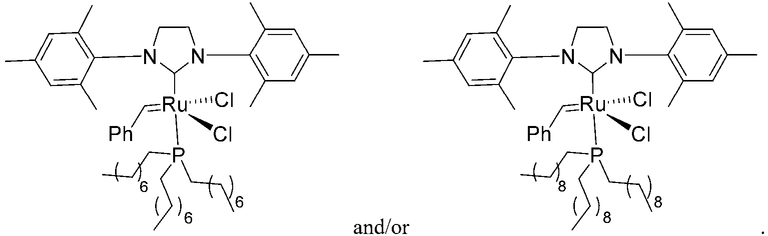

In one embodiment of the present disclosure, the component B is a ruthenium alkylidene compound of Formula I.

In one embodiment of the present disclosure, the component B is a ruthenium alkylidene compound of Formula II.

In one embodiment of the present disclosure, the component B consists of a ruthenium alkylidene compound of Formula I and a ruthenium alkylidene compound of Formula II, for example,

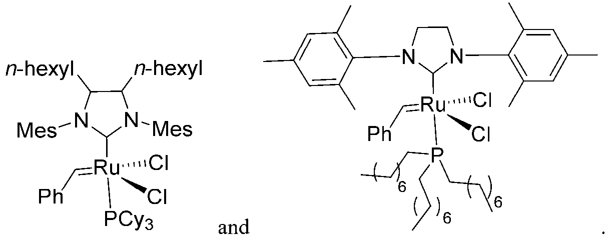

In one embodiment of the present disclosure, the component B consists of a ruthenium alkylidene compound of Formula I and a ruthenium alkylidene compound of Formula II, wherein the molar ratio of the ruthenium alkylidene compound of Formula I to the ruthenium alkylidene compound of Formula II is 1:(1.5-5), for example, 1:2.

In one embodiment of the present disclosure, the cycloolefin resin composition M1 further comprises component C, wherein the component C is one or more selected from solid paraffin, liquid paraffin, and chlorinated paraffin with a chlorine content of 5 wt% to 65 wt%, for example, liquid paraffin, chlorinated paraffin with a chlorine content of 5 wt% to 65 wt%, or a mixture of liquid paraffin and chlorinated paraffin with a chlorine content of 5 wt% to 65 wt%, wherein in the mixture, the mass ratio of the liquid paraffin to the chlorinated paraffin with a chlorine content of 5 wt% to 65 wt% is, for example, (10-20):1, further for example, 11:1;
preferably, the ratio of the total mass of the component C and the component B to the mass of the component A is 1:(15-200), for example, 1:(15-55), further for example, 1:(20-50).

In one embodiment of the present disclosure, the cycloolefin resin composition M1 further comprises component C, wherein the component C is liquid paraffin and/or chlorinated paraffin with a chlorine content of 5 wt% to 65 wt%, and the mass ratio of the component C to the component B is (15-70):1, for example, 21:1, 28:1, or 64:1.

In one embodiment of the present disclosure, the cycloolefin resin composition M1 further comprises component C, wherein the component C is liquid paraffin, and the mass ratio of the component C to the component B is (60-70):1, for example, 64:1.

In one embodiment of the present disclosure, the cycloolefin resin composition M1 further comprises component C, wherein the component C is chlorinated paraffin with a chlorine content of 5 wt% to 65 wt%, and the mass ratio of the component C to the component B is (15-35):1, for example, 21:1 or 28:1.

In one embodiment of the present disclosure, the cycloolefin resin composition M1 further comprises component C, wherein the component C is a mixture of liquid paraffin and chlorinated paraffin with a chlorine content of 5 wt% to 65 wt%, wherein in the mixture, the mass ratio of the liquid paraffin to the chlorinated paraffin with a chlorine content of 5 wt% to 65 wt% is, for example, (10-20):1, for example, 11:1; and the mass ratio of the component C to the component B is (60-70):1, for example, 64:1.

Preferably, in any one of the above embodiments, the chlorinated paraffin with a chlorine content of 5 wt% to 65 wt% is chlorinated paraffin with a chlorine content of 5 wt% to 52 wt%.

In one embodiment of the present disclosure, the cycloolefin resin composition M1 further comprises component D, wherein the component D is one or more selected from thermoplastic resin, linear or branched chain olefin with a carbon chain length of C₁₂ or more, linear or branched chain alkane with a carbon chain length of C₁₂ or more, solid paraffin, and mineral oil; and the thermoplastic resin, chain olefin, and chain alkane contain only C and H elements;
preferably, the thermoplastic resin is one or more selected from ethylene-propylene rubber (EP), ethylene-propylene-diene monomer rubber (EPDM), polyolefin elastomer (POE), liquid butyl rubber (LBR), styrene-butadiene rubber (SBR), hydrogenated styrene-butadiene rubber (SEBS), and styrene-butadiene-styrene block copolymer (SBS);
preferably, the thermoplastic resin is added with an additive, wherein the additive is an organic phosphorus compound and/or an antioxidant, the organic phosphorus compound is, for example, one or more selected from triphenylphosphine, tricyclohexylphosphine, trioctylphosphine, and tributylphosphine, and the antioxidant is preferably a hindered phenol antioxidant, for example, one or more selected from an antioxidant 264 (CAS No. 128-37-0), an antioxidant 1010 (CAS No. 6683-19-8), and an antioxidant 168 (CAS No. 31570-04-4); preferably, based on the total mass of component A and component D, the mass percentage of the additive is 0-0.5 wt%, for example, 0-0.3 wt%;
preferably, the linear or branched chain alkane with a carbon chain length of C₁₂ or more is *n-*pentadecane;
preferably, based on the total mass of component A and component D, the mass percentage of the component D is 0-20 wt%, preferably 0-10 wt%.

In one embodiment of the present disclosure, the cycloolefin resin composition M1 consists of the component A according to any one of the above embodiments and the component B according to any one of the above embodiments.

In one embodiment of the present disclosure, the cycloolefin resin composition M1 consists of the component A according to any one of the above embodiments, the component B according to any one of the above embodiments, and the component C according to any one of the above embodiments.

In one embodiment of the present disclosure, the cycloolefin resin composition M1 consists of the component A according to any one of the above embodiments, the component B according to any one of the above embodiments, and the component D according to any one of the above embodiments.

In one embodiment of the present disclosure, the cycloolefin resin composition M1 consists of the component A according to any one of the above embodiments, the component B according to any one of the above embodiments, the component C according to any one of the above embodiments, and the component D according to any one of the above embodiments.

In one embodiment of the present disclosure, the cycloolefin resin composition M1 consists of components according to any of the following schemes:
Scheme C1: component A and component B,
   the component A consists of dicyclopentadiene and tricyclopentadiene, wherein the mass percentage of dicyclopentadiene in the component A is 90%, and the mass percentage of tricyclopentadiene in the component A is 10%;
   the component B is 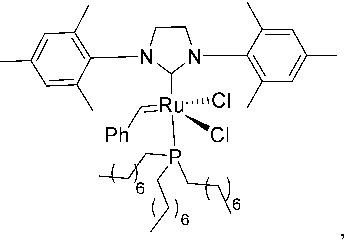
   the molar ratio of Ru in the component B to the monomer of cycloolefin in the component A is 1:10000;
Scheme C2: component A and component B,
   the component A is tetracyclododecene;
   the component B is 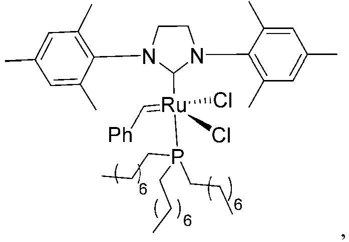
   the molar ratio of Ru in the component B to the monomer of cycloolefin in the component A is 1:15000;
Scheme C3: component A and component B,
   the component A is dihydrodicyclopentadiene;
   the component B is 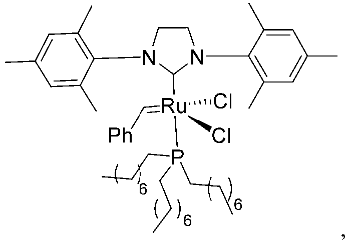
   the molar ratio of Ru in the component B to the monomer of cycloolefin in the component A is 1:15000;
Scheme C4: component A, component B, and component C,
   the component A consists of dicyclopentadiene and 5-ethylidene-2-norbornene, wherein the mass percentage of dicyclopentadiene in the component A is 98%, and the mass percentage of 5-ethylidene-2-norbornene in the component A is 2%;
   the component B is 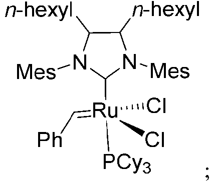
   the molar ratio of Ru in the component B to the monomer of cycloolefin in the component A is 1:10000;
   the component C is liquid paraffin;
   the ratio of the total mass of the component C and the component B to the mass of the component A is 1:20;
Scheme C5: component A, component B, and component C
   the component A consists of dicyclopentadiene and tricyclopentadiene, wherein the mass percentage of dicyclopentadiene in the component A is 90%, and the mass percentage of tricyclopentadiene in the component A is 10%;
   the component B is 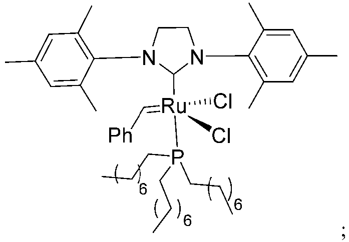
   the molar ratio of Ru in the component B to the monomer of cycloolefin in the component A is 1:10000;
   the component C is chlorinated paraffin with a chlorine content of 5%;
   the ratio of the total mass of the component C and the component B to the mass of the component A is 1:50;
Scheme C6: component A, component B, and component C
   the component A consists of dicyclopentadiene and tricyclopentadiene, wherein the mass percentage of dicyclopentadiene in the component A is 90%, and the mass percentage of tricyclopentadiene in the component A is 10%;
   the component B is 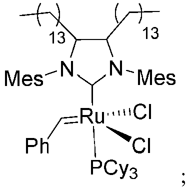
   the molar ratio of Ru in the component B to the monomer of cycloolefin in the component A is 1:10000;
   the component C is chlorinated paraffin with a chlorine content of 5%;
   the ratio of the total mass of the component C and the component B to the mass of the component A is 1:50;
Scheme C7: component A and component B
   the component A consists of dicyclopentadiene, tricyclopentadiene, and tetracyclopentadiene, wherein the mass percentage of dicyclopentadiene in the component A is 79%, the mass percentage of tricyclopentadiene in the component A is 20%, and the mass percentage of tetracyclopentadiene in the component A is 1%;
   the component B is 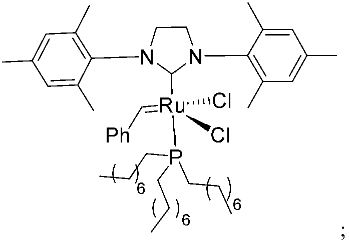
   the molar ratio of Ru in the component B to the monomer of cycloolefin in the component A is 1:10000;
Scheme C8: component A, component B, and component C
   the component A consists of dicyclopentadiene, tricyclopentadiene, and tetracyclopentadiene, wherein the mass percentage of dicyclopentadiene in the component A is 79%, the mass percentage of tricyclopentadiene in the component A is 20%, and the mass percentage of tetracyclopentadiene in the component A is 1%;
   the component B is 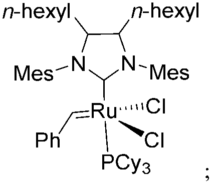
   the molar ratio of Ru in the component B to the monomer of cycloolefin in the component A is 1:10000;
   the component C is liquid paraffin;
   the ratio of the total mass of the component C and the component B to the mass of the component A is 1:200;
Scheme C9: component A and component B
   the component A consists of dicyclopentadiene, tricyclopentadiene, and tetracyclopentadiene, wherein the mass percentage of dicyclopentadiene in the component A is 79%, the mass percentage of tricyclopentadiene in the component A is 20%, and the mass percentage of tetracyclopentadiene in the component A is 1%;
   the component B is 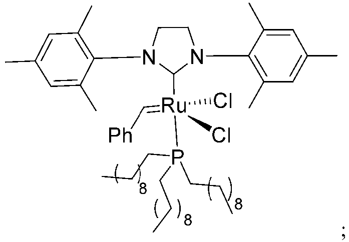
   the molar ratio of Ru in the component B to the monomer of cycloolefin in the component A is 1:10000;
[0116]Scheme C10: component A and component B
   the component A consists of dicyclopentadiene, tricyclopentadiene, and tetracyclopentadiene, wherein the mass percentage of dicyclopentadiene in the component A is 79%, the mass percentage of tricyclopentadiene in the component A is 20%, and the mass percentage of tetracyclopentadiene in the component A is 1%;
   the component B is 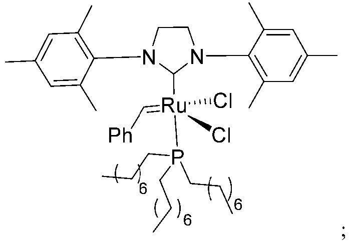
   the molar ratio of Ru in the component B to the monomer of cycloolefin in the component A is 1:50000;
Scheme C11: component A, component B, and component C
   the component A consists of dicyclopentadiene, tricyclopentadiene, dihydrodicyclopentadiene, and cyclohexene, wherein the mass percentage of dicyclopentadiene in the component A is 80%, the mass percentage of tricyclopentadiene in the component A is 15%, the mass percentage of dihydrodicyclopentadiene in the component A is 4.5%, and the mass percentage of cyclohexene in the component A is 0.5%;
   the component B is 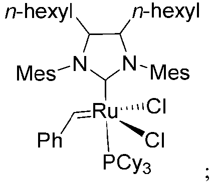
   the molar ratio of Ru in the component B to the monomer of cycloolefin in the component A is 1:9500;
   the component C consists of liquid paraffin and chlorinated paraffin with a chlorine content of 52 wt%, wherein the mass ratio of liquid paraffin to chlorinated paraffin with a chlorine content of 52 wt% is 11:1;
   the ratio of the total mass of the component C and the component B to the mass of the component A is 1:20;
Scheme C12: component A and component B
   the component A consists of dicyclopentadiene and tricyclopentadiene, wherein the mass percentage of dicyclopentadiene in the component A is 90%, and the mass percentage of tricyclopentadiene in the component A is 10%;
   the component B consists of 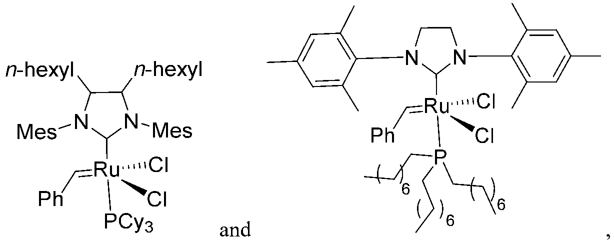 wherein the molar ratio of 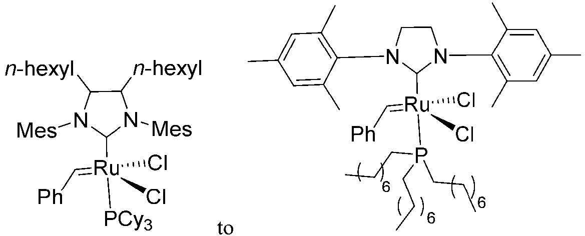 is 1:2;
   the molar ratio of Ru in the component B to the monomer of cycloolefin in the component A is 1:10000;
Scheme C13: component A and component B
   the component A consists of dicyclopentadiene and tricyclopentadiene, wherein the mass percentage of dicyclopentadiene in the component A is 90%, and the mass percentage of tricyclopentadiene in the component A is 10%;
   the component B is 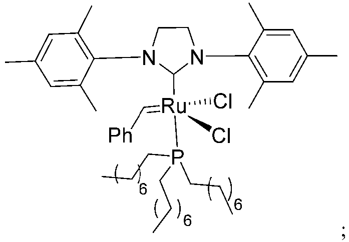
   the molar ratio of Ru in the component B to the monomer of cycloolefin in the component A is 1:7500;
Scheme C14: component A, component B, and component D
   the component A consists of dicyclopentadiene and tricyclopentadiene, wherein the mass percentage of dicyclopentadiene in the component A is 90%, and the mass percentage of tricyclopentadiene in the component A is 10%;
   the component B is 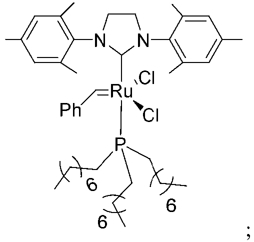
   the molar ratio of Ru in the component B to the monomer of cycloolefin in the component A is 1:10000;
   the component D is a mixture of n-pentadecane, EPDM, SBS, and mineral oil;
   based on the total mass of the component A and the component D, the mass percentage of *n-*pentadecane is 4-5%, and the mass percentages of EPDM, SBS, and mineral oil are independently 2-3%;
Scheme C15: component A, component B, and component D
   the component A consists of dicyclopentadiene and tricyclopentadiene, wherein the mass percentage of dicyclopentadiene in the component A is 90%, and the mass percentage of tricyclopentadiene in the component A is 10%;
   the component B is 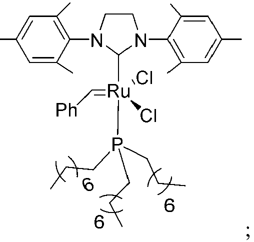
   the molar ratio of Ru in the component B to the monomer of cycloolefin in the component A is 1:10000;
   the component D is a mixture of n-pentadecane, cetene, EPDM, SEBS, POE, and mineral oil;
   based on the total mass of the component A and the component D, the mass percentage of *n-*pentadecane is 2-4%, the mass percentage of cetene is 0.3-1%, the mass percentage of EPDM is 2-3%, the mass percentage of SEBS is 0.3-1%, the mass percentage of POE is 0.5-1.2%, and the mass percentage of mineral oil is independently 2-3%;
Scheme C16: component A, component B, and component D
   the component A consists of dicyclopentadiene and tricyclopentadiene, wherein the mass percentage of dicyclopentadiene in the component A is 90%, and the mass percentage of tricyclopentadiene in the component A is 10%;
   the component B is 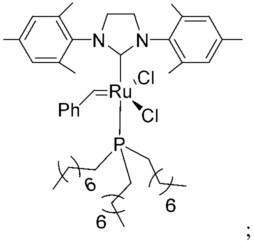
   the component D is a mixture of an antioxidant 264, triphenylphosphine, n-pentadecane, EPDM, SEBS, and POE;
   based on the total mass of the component A and the component D, the mass percentage of the antioxidant 264 is 0.1-0.2%, the mass percentage of triphenylphosphine is 0.02-0.1%, the mass percentage of n-pentadecane is 4-5%, the mass percentage of EPDM is 1-2%, the mass percentage of SEBS is 1-2%, and the mass percentage of POE is 1-2%.

In one embodiment of the present disclosure, the substrate material for the high-frequency and high-speed information transmission device is a copper-clad laminate.

The present disclosure further provides a cycloolefin resin composition M1, which is the cycloolefin resin composition M1 according to any one of the above embodiments, and in the cycloolefin resin composition M1, the mass percentage of the component A is 80% or more, but less than 100%.

The present disclosure further provides a cycloolefin resin composition M2, which consists of the component A according to any one of the above embodiments and the component B according to any one of the above embodiments.

The present disclosure further provides a cycloolefin resin composition M3, which consists of the component A according to any one of the above embodiments, the component B according to any one of the above embodiments, and the component C according to any one of the above embodiments.

The present disclosure further provides a cycloolefin resin composition M4, which consists of the component A according to any one of the above embodiments, the component B according to any one of the above embodiments, and the component D according to any one of the above embodiments.

The present disclosure further provides a cycloolefin resin composition M5, which consists of the component A according to any one of the above embodiments, the component B according to any one of the above embodiments, the component C according to any one of the above embodiments, and the component D according to any one of the above embodiments.

In the present disclosure,
"The component A according to any one of the above embodiments" indicates that the type and content or other characteristics of component A are as described in any one of the above embodiments, and are not limited to only the type of component A as described in any one of the above embodiments;
"The component B according to any one of the above embodiments" indicates that the type and content or other characteristics of component B are as described in any one of the above embodiments, and are not limited to only the type of component B as described in any one of the above embodiments;
"The component C according to any one of the above embodiments" indicates that the type and content or other characteristics of component C are as described in any one of the above embodiments, and are not limited to only the type of component C as described in any one of the above embodiments;
"The component D according to any one of the above embodiments" indicates that the type and content or other characteristics of component D are as described in any one of the above embodiments, and are not limited to only the type of component D as described in any one of the above embodiments. The present disclosure further provides a cycloolefin resin material, which is prepared using the cycloolefin resin composition M1, M2, M3, M4, or M5 according to any one of the above embodiments as a raw material.

In one embodiment of the present disclosure, the cycloolefin resin material exhibits a dielectric loss of < 0.001 at a frequency of ≥ 1 GHz (e.g., 1-12 GHz, further e.g., 10 GHz), for example, a dielectric loss of 0.00067, 0.00069, 0.00071, 0.00072, 0.00073, 0.00075, 0.00077, 0.00078, 0.00079, 0.00085, 0.00086, 0.00087, 0.00088, 0.00089, 0.0009, or 0.00091.

In one embodiment of the present disclosure, the cycloolefin resin material exhibits a dielectric constant of < 2.5 at a frequency of ≥ 1 GHz (e.g., 1-12 GHz, further e.g., 10 GHz), for example, a dielectric constant of 2.23, 2.26, 2.27, 2.28, 2.29, 2.30, 2.31, or 2.32.

In one embodiment of the present disclosure, the cycloolefin resin material has a glass transition temperature of ≥ 135°C, for example, 138°C, 149°C, 152°C, 155°C, 157°C, 160°C, 162°C, 164°C, 165°C, 166°C, 175°C, 177°C, 186°C, 189°C, or 190°C.

In one embodiment of the present disclosure, the cycloolefin resin material has a heat deflection temperature of ≥ 110°C, for example, 115°C, 117°C, 119°C, 122°C, 126°C, 127°C, 134°C, 137°C, 142°C, 144°C, 147°C, 158°C, or 167°C.

The cycloolefin resin material can be prepared using conventional liquid molding processes in the art, such as a reaction injection molding (RIM) process, a resin transfer molding (RTM) process, and a vacuum-assisted resin infusion (VARI) process, wherein in the reaction injection molding (RIM) process, the resin transfer molding (RTM) process, and the vacuum-assisted resin infusion (VARI) process, the temperature for molding may be 40-145°C, for example, 40°C, 45°C, 60°C, 70°C, 80°C, or 140°C, preferably 40-90°C; and the time for curing and molding may be 1-120 min, for example, 3.5 min, 5 min, 10 min, 20 min, 25 min, or 30 min, preferably 2-60 min.

The ROMP polymerization used in the cycloolefin resin material of the present disclosure is a frontal polymerization technique, meaning that the reaction is substantially completed within seconds once initiated, typically with an initiation time between 15 and 90 s (adjustable). After frontal polymerization is completed, the subsequent heat preservation process primarily increases the degree of polymerization or cross-linking of the material to a certain extent. Therefore, after the initiation is completed within the range of 40-145°C, the minimum performance requirements of the present disclosure have already been met.

The present disclosure further provides a preparation method for a cycloolefin resin material, comprising the following steps: using the cycloolefin resin composition M1, M2, M3, M4, or M5 according to any one of the above embodiments as a raw material, mixing each component in the resin composition, curing, and molding via a liquid molding process to prepare the cycloolefin resin material, wherein the temperature for the curing and molding is 40-145°C, and the time for the curing and molding is 1-120 min.

In one embodiment of the present disclosure, the temperature for the curing and molding is 40°C, 45°C, 60°C, 70°C, 80°C, or 140°C.

In one embodiment of the present disclosure, the time for the curing and molding is 2-60 min, for example, 3-30 min, further for example, 3.5 min, 5 min, 10 min, 20 min, 25 min, or 30 min.

In one embodiment of the present disclosure, the liquid molding process is a reaction injection molding (RIM) process, a resin transfer molding process (RTM) , or a vacuum-assisted resin infusion (VARI) process.

In one embodiment of the present disclosure, the liquid molding process is a resin transfer molding (RTM) process, comprising the following steps: adding a mixture of each component in the cycloolefin resin composition M1, M2, M3, M4, or M5 into a mold, curing and molding.

In one embodiment of the present disclosure, the liquid molding process is a reaction injection molding (RIM) process, wherein the raw material is the cycloolefin resin composition M3, comprising the following steps: adding a mixture of each component in the cycloolefin resin composition M3 into a mold, curing and molding.

Preferably, the mixture of each component in the cycloolefin resin composition M3 is obtained by mixing each component of the cycloolefin resin composition M3 at 1-3 MPa (e.g., 2 MPa).

Preferably, the mixture of each component in the cycloolefin resin composition M3 is added into the mold within 4-6 s (e.g., 5 s).

In one embodiment of the present disclosure, the liquid molding process is a vacuum-assisted resin infusion (VARI) process, comprising the following steps: adding a mixture of each component in the cycloolefin resin composition M1, M2, M3, M4, or M5 into a mold, curing and molding.

In one embodiment of the present disclosure, in the reaction injection molding (RIM) process, the resin transfer molding (RTM) process, or the vacuum-assisted resin infusion (VARI) process, the mixture is a mixture of component A in each resin composition and other components in each resin composition, wherein the component A may be treated as follows: stirring at 60°C-125°C for 4-12 hours, and cooling to room temperature for later use.

In one embodiment of the present disclosure, in the reaction injection molding (RIM) process, the resin transfer molding (RTM) process, or the vacuum-assisted resin infusion (VARI) process, the temperature of the mold is 40-145°C;
preferably, in the reaction injection molding (RIM) process or the resin transfer molding (RTM) process, the temperature on one side of the mold is 40-145°C (for example, 60-140°C); the temperature on the other side of the mold is 40-145°C (for example, 40-140°C).
more preferably, in the reaction injection molding (RIM) process or the resin transfer molding (RTM) process, the temperature of the mold is any one of the following schemes:
   Scheme 1: the temperature on one side of the mold is 70°C, and the temperature on the other side of the mold is 40°C;
   Scheme 2: the temperature on one side of the mold is 80°C, and the temperature on the other side of the mold is 45°C;
   Scheme 3: the temperature on one side of the mold is 140°C, and the temperature on the other side of the mold is 140°C;
   Scheme 4: the temperature on one side of the mold is 60°C, and the temperature on the other side of the mold is 40°C.

In one embodiment of the present disclosure, the reaction injection molding (RIM) process, the resin transfer molding (RTM) process, or the vacuum-assisted resin infusion (VARI) process further comprises a post-curing stage, wherein the temperature during the post-curing is 60-145°C (for example, 140°C), and the time for the post-curing is 0-60 min (for example, 20 min).

The present disclosure further provides a cycloolefin resin material prepared by the preparation method for the cycloolefin resin material according to any one of the above embodiments.

In one embodiment of the present disclosure, the cycloolefin resin material exhibits a dielectric loss of < 0.001 at a frequency of ≥ 1 GHz (e.g., 1-12 GHz, further e.g., 10 GHz), for example, a dielectric loss of 0.00067, 0.00069, 0.00071, 0.00072, 0.00073, 0.00075, 0.00077, 0.00078, 0.00079, 0.00085, 0.00086, 0.00087, 0.00088, 0.00089, 0.0009, or 0.00091.

In one embodiment of the present disclosure, the cycloolefin resin material exhibits a dielectric constant of < 2.5 at a frequency of ≥ 1 Ghz (e.g., 1-12 GHz, further e.g., 10 GHz), for example, a dielectric constant of 2.23, 2.26, 2.27, 2.28, 2.29, 2.30, 2.31, or 2.32.

In one embodiment of the present disclosure, the cycloolefin resin material has a glass transition temperature of ≥ 135°C, for example, 138°C, 149°C, 152°C, 155°C, 157°C, 160°C, 162°C, 164°C, 165°C, 166°C, 175°C, 177°C, 186°C, 189°C, or 190°C.

In one embodiment of the present disclosure, the cycloolefin resin material has a heat deflection temperature of ≥ 110°C, for example, 115°C, 117°C, 119°C, 122°C, 126°C, 127°C, 134°C, 137°C, 142°C, 144°C, 147°C, 158°C, or 167°C.

The present disclosure further provides a method for reducing a dielectric constant and/or dielectric loss of a cycloolefin resin material, comprising: introducing the component B according to any one of the above embodiments into the component A according to any one of the above embodiments when preparing the cycloolefin resin material, wherein the molar ratio of Ru in the component B to the monomer of cycloolefin in the component A is 1:(7500-60000);
preferably, the raw material of the cycloolefin resin material is the cycloolefin resin composition M1, M2, M3, M4, or M5 according to any one of the above embodiments;
preferably, a preparation method for the cycloolefin resin material is as described in the preparation method for the cycloolefin resin material according to any one of the above embodiments.

In one embodiment of the present disclosure, the molar ratio of Ru in the component B to the monomer of cycloolefin in the component A is 1:(7500-50000), for example, 1:7500, 1:9500, 1:10000, 1:15000, or 1:50000.

The present disclosure further provides a prepreg comprising the cycloolefin resin material according to any one of the above embodiments.

The present disclosure further provides a copper-clad laminate comprising the prepreg according to any one of the above embodiments.

The present disclosure further provides a printed circuit board comprising the copper-clad laminate according to any one of the above embodiments.

On the basis of conforming to common sense in the art, the above preferred conditions can be combined arbitrarily to obtain various preferred examples of the present disclosure.

The reagents and raw materials used in the present disclosure are commercially available.

The positive and progressive effects of the present disclosure lie in that:
(1) The cycloolefin resin material prepared using the cycloolefin resin composition of the present disclosure as the raw material exhibits significantly lower dielectric loss and dielectric constant (Dₖ < 2.5 and D_{f} < 0.001) in the high-frequency range (1-12 GHz, e.g., 10 GHz) compared to cycloolefin resin materials prepared using conventional catalysts; moreover, the prepared material demonstrates excellent heat resistance, with a heat deflection temperature HDT ≥ 110°C and a glass transition temperature Tg ≥ 135°C;
(2) The cycloolefin resin system disclosed in the present disclosure can accommodate various liquid molding processes (RIM, RTM, and VARI), with high molding efficiency and low energy consumption.

### DETAILED DESCRIPTION OF THE INVENTION

The present disclosure is further described below by the way of examples, but the present disclosure is not thereby limited to the scope of the described examples. The experimental methods for which the specific conditions are not specified in the following examples are selected according to the conventional methods and conditions, or according to the commodity instructions.

In the following examples, the dielectric properties (including dielectric constant and dielectric loss) of the molded materials are tested in accordance with ASTM D2520.

The heat deflection temperature (HDT) is determined according to the method specified in GB/T 1634.2-2019; Tg value is determined using dynamic thermomechanical analysis (DMA) test in a dual-cantilever mode, with a test temperature range of 30-200°C, and the Tg value is determined by measuring the storage modulus of the material during the programmed temperature ramping at a ramp rate of 10 K/min.

In the following examples, where the molar ratio of monomer to Ru is involved, the monomer refers to all the cyclic olefin monomers in the feed.

### Example 1: Thermosetting Material Example (DCPD-TCPD + Catalyst of Formula IV + RTM)

Preparation of cycloolefin composition: 900 g of dicyclopentadiene and 100 g of tricyclopentadiene (TCPD, 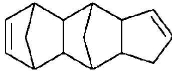 ) were mixed, heated to 60°C under a nitrogen atmosphere, stirred for 4 h, and cooled to room temperature for later use;

Liquid ruthenium catalyst: 0.69 g of a liquid ruthenium alkylidene catalyst of Formula IV (Mw = 939.19 g/mol);

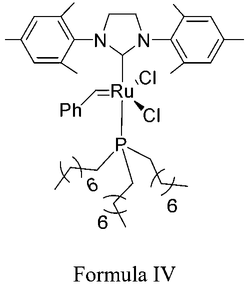

High-frequency low-dielectric material molding: The molding was carried out using the RTM process. Before the molding was started, the mold was preheated, with one side of the mold at 70°C and the other side at 40°C. 1000 g of cycloolefin composition and 0.69 g of liquid ruthenium catalyst were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump. After curing for 5 min, the molded sample was demolded.

Performance testing of the molded material: The HDT of the obtained material was 134°C, and the Tg was 162°C; under a test frequency of 10 GHz, the material's Dₖ was measured as 2.28 and D_{f} as 0.00071.

### Example 2.1: Thermoplastic Material Example (DMON + Catalyst of Formula IV + RTM)

### Cycloolefin composition: 1000 g of tetracyclododecene (Formula V);

Liquid ruthenium catalyst: 0.39 g of a liquid ruthenium alkylidene catalyst of Formula IV;

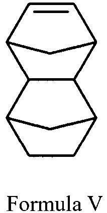

High-frequency low-dielectric material molding: The molding was carried out using the RTM process. Before the molding was started, the mold was preheated, with one side of the mold at 70°C and the other side at 40°C. 1000 g of cycloolefin composition and 0.39 g of liquid ruthenium catalyst were thoroughly mixed and dissolved to obtain a cycloolefin resin mixture (the molar ratio of monomer to Ru was 15000:1). The cycloolefin resin mixture was pumped into a mold cavity with a thickness of 1.5 mm using an injection pump. After curing for 5 min, the molded sample was demolded.

Performance testing of the molded material: The HDT of the obtained material was 142°C, and the Tg was 190°C; under a test frequency of 10 GHz, the material's Dₖ was measured as 2.29 and D_{f} as 0.00075.

### Example 2.2: Thermoplastic Material Example (Dihydrodicyclopentadiene + Catalyst of Formula IV + RTM)

### Cycloolefin composition: 1000 g of dihydrodicyclopentadiene (Formula VI);

Liquid ruthenium catalyst: 0.47 g of a liquid ruthenium alkylidene catalyst of Formula IV;

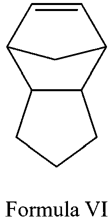

High-frequency low-dielectric material molding: The molding was carried out using the RTM process. Before the molding was started, the mold was preheated, with one side of the mold at 70°C and the other side at 40°C. 1000 g of cycloolefin composition and 0.47 g of liquid ruthenium catalyst were thoroughly mixed and dissolved to obtain a cycloolefin resin mixture (the molar ratio of monomer to Ru was 15000:1). The cycloolefin resin mixture was pumped into a mold cavity with a thickness of 1.5 mm using an injection pump. After curing for 5 min, the molded sample was demolded.

Performance testing of the molded material: The HDT of the obtained material was 117°C, and the Tg was 152°C; under a test frequency of 10 GHz, the material's Dₖ was measured as 2.29 and D_{f} as 0.00077.

### Example 3: RIM Process Molding 1 (DCPD-ENB + Catalyst of Formula VII - Paraffin)

### Preparation of cycloolefin composition RIM-A mixture: 980 g of dicyclopentadiene and 20 g of 5-ethylidene-2-norbomene were thoroughly mixed to form a homogeneous liquid composition;

Preparation of liquid ruthenium catalyst composition RIM-B mixture: 0.77 g of ruthenium alkylidene catalyst of Formula VII (Mw: 1017.3 g/mol) and 49.23 g of liquid paraffin were thoroughly mixed to form a homogeneous liquid ruthenium catalyst composition.

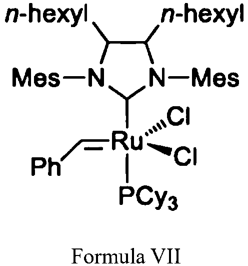

High-frequency low-dielectric material molding: The molding was carried out using the RIM process. Before the molding was started, the mold was preheated, with one side of the mold at 70°C and the other side at 40°C. The RIM-A mixture and the RIM-B mixture were mixed at a mass ratio of 20:1 and the blend was injected (the molar ratio of monomer to Ru was 10000:1) under an injection pressure of 2.0 MPa. The mold cavity with a thickness of 1.5 mm was filled within 5 s, followed by a curing time of 3.5 min, and then the molded sample was demolded.

Performance testing of the molded material: The HDT of the obtained material was 119°C, and the Tg was 155°C; under a test frequency of 10 GHz, the material's Dₖ was measured as 2.23 and D_{f} as 0.00079.

### Example 4.1: RIM Process Molding 2 (DCPD-TCPD + Catalyst of Formula IV - Chlorinated Paraffin)

Preparation of cycloolefin composition RIM-A mixture: 900 g of dicyclopentadiene and 100 g of tricyclopentadiene (TCPD) were mixed, heated to 60°C under a nitrogen atmosphere, stirred for 4 h, and cooled to room temperature for later use;
Liquid ruthenium catalyst composition RIM-B mixture: 0.69 g of liquid ruthenium alkylidene catalyst of Formula IV was fully stirred and dissolved in 19.31 g of chlorinated paraffin with a chlorine content of 5%;

High-frequency low-dielectric material molding: The molding was carried out using the RIM process. Before the molding was started, the mold was preheated, with one side of the mold at 70°C and the other side at 40°C. The RIM-A mixture and the RIM-B mixture were mixed at a mass ratio of 50:1 and the blend was injected (the molar ratio of monomer to Ru was 10000:1) under an injection pressure of 2.0 MPa. The mold cavity with a thickness of 1.5 mm was filled within 5 s, followed by a curing time of 5 min, and then the molded sample was demolded.

Performance testing of the molded material: The HDT of the obtained material was 122°C, and the Tg was 157°C; under a test frequency of 10 GHz, the material's Dₖ was measured as 2.31 and D_{f} as 0.00087.

### Example 4.2: RIM Process Molding 2 (DCPD-TCPD + Catalyst of Formula VIII - Chlorinated Paraffin)

Preparation of cycloolefin composition RIM-A mixture: 900 g of dicyclopentadiene and 100 g of tricyclopentadiene (TCPD) were mixed, heated to 60°C under a nitrogen atmosphere, stirred for 4 h, and cooled to room temperature for later use;
Liquid ruthenium catalyst composition RIM-B resin mixture: 0.91 g of liquid ruthenium alkylidene catalyst of Formula VIII was fully stirred and dissolved in 19.09 g of chlorinated paraffin with a chlorine content of 5%;

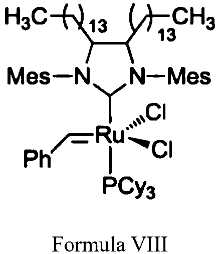

High-frequency low-dielectric material molding: The molding was carried out using the RIM process. Before the molding was started, the mold was preheated, with one side of the mold at 70°C and the other side at 40°C. The RIM-A resin mixture and the RIM-B resin mixture were mixed at a mass ratio of 50:1 and the blend was injected (the molar ratio of monomer to Ru was 10000:1) under an injection pressure of 2.0 MPa. The mold cavity with a thickness of 1.5 mm was filled within 5 s, followed by a curing time of 5 min, and then the molded sample was demolded.

Performance testing of the molded material: The HDT of the obtained material was 126°C, and the Tg was 160°C; under a test frequency of 10 GHz, the material's Dₖ was measured as 2.30 and D_{f} as 0.00086.

### Example 5.1: VARI Process Molding (DCPD-TCPD-TeCPD + Catalyst of Formula IV)

Preparation of cycloolefin composition: 790 g of dicyclopentadiene, 200 g of tricyclopentadiene (TCPD), and 10 g of tetracyclopentadiene (TeCPD, 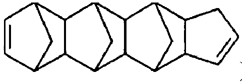 ) were mixed, heated to 125°C under a nitrogen atmosphere, stirred for 12 h, and cooled to room temperature for later use;

### Liquid ruthenium catalyst: 0.66 g of a liquid ruthenium alkylidene catalyst of Formula IV;

High-frequency low-dielectric material molding: The molding was carried out using the VARI process. Before the molding was started, the mold was preheated to a temperature of 70°C. Then, the mold cavity was evacuated to -0.09 MPaG. The pressure was kept at this level during the filling process. 1000 g of cycloolefin composition and 0.66 g of liquid ruthenium catalyst were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump. Once the resin mixture filled up the mold, the vacuum valve was switched off immediately. After curing for 5 min, the molded sample was demolded.

Performance testing of the molded material: The HDT of the obtained material was 147°C, and the Tg was 177°C; under a test frequency of 10 GHz, the material's Dₖ was measured as 2.26 and D_{f} as 0.00067.

### Example 5.2: VARI Process Molding (DCPD-TCPD-TeCPD + Catalyst of Formula VII-Liquid Paraffin)

Preparation of cycloolefin composition: 790 g of dicyclopentadiene, 200 g of tricyclopentadiene (TCPD), and 10 g of tetracyclopentadiene (TeCPD) were mixed, heated to 125°C under a nitrogen atmosphere, stirred for 12 h, and cooled to room temperature for later use;
Liquid ruthenium catalyst composition: 0.71 g of ruthenium alkylidene catalyst of Formula VII was dissolved in 4.29 g of liquid paraffin;
High-frequency low-dielectric material molding: The molding was carried out using the VARI process. Before the molding was started, the mold was preheated to a temperature of 70°C. Then, the mold cavity was evacuated to -0.09 MPaG. The pressure was kept at this level during the filling process. 1000 g of cycloolefin composition and 5 g of liquid ruthenium catalyst composition were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump. Once the resin mixture filled up the mold, the vacuum valve was switched off immediately. After curing for 5 min, the molded sample was demolded.
Performance testing of the molded material: The HDT of the obtained material was 144°C, and the Tg was 175°C; under a test frequency of 10 GHz, the material's Dₖ was measured as 2.29 and D_{f} as 0.00072.

### Example 5.3: VARI Process Molding (DCPD-TCPD-TeCPD + Catalyst of Formula IX)

Preparation of cycloolefin composition: 790 g of dicyclopentadiene, 200 g of tricyclopentadiene (TCPD), and 10 g of tetracyclopentadiene (TeCPD) were mixed, heated to 125°C under a nitrogen atmosphere, stirred for 12 h, and cooled to room temperature for later use;
Liquid ruthenium catalyst: 0.72 g of a liquid ruthenium alkylidene catalyst of Formula IX;

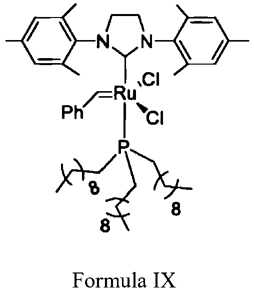

High-frequency low-dielectric material molding: The molding was carried out using the VARI process. Before the molding was started, the mold was preheated to a temperature of 70°C. Then, the mold cavity was evacuated to -0.09 MPaG. The pressure was kept at this level during the filling process. 1000 g of cycloolefin composition and 0.72 g of liquid ruthenium catalyst were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump. Once the resin mixture filled up the mold, the vacuum valve was switched off immediately. After curing for 5 min, the molded sample was demolded.

Performance testing of the molded material: The HDT of the obtained material was 144°C, and the Tg was 175°C; under a test frequency of 10 GHz, the material's Dₖ was measured as 2.28 and D_{f} as 0.00069.

### Example 6: Monomer:Ru = 50000:1 (Low Catalyst Amount)

Preparation of cycloolefin composition: 790 g of dicyclopentadiene, 200 g of tricyclopentadiene (TCPD), and 10 g of tetracyclopentadiene (TeCPD) were mixed, heated to 125°C under a nitrogen atmosphere, stirred for 12 h, and cooled to room temperature for later use;
[0255Liquid ruthenium catalyst: 0.132 g of a liquid ruthenium alkylidene catalyst of Formula IV;
High-frequency low-dielectric material molding: The molding was carried out using the VARI process. Before the molding was started, the mold was preheated, with one side of the mold at 80°C and the other side at 45°C. Then, the mold cavity was evacuated to -0.09 MPaG. The pressure was kept at this level during the filling process. 1000 g of cycloolefin composition and 0.132 g of liquid ruthenium catalyst were thoroughly mixed and dissolved to obtain a cycloolefin resin mixture (the molar ratio of monomer to Ru was 50000:1). The cycloolefin resin mixture was pumped into a mold with a thickness of 1.5 mm using an injection pump. Once the resin mixture filled up the mold, the vacuum valve was switched off immediately. After curing for 30 min, the molded sample was demolded.
Performance testing of the molded material: The HDT of the obtained material was 115°C, and the Tg was 138°C; under a test frequency of 10 GHz, the material's Dₖ was measured as 2.27 and D_{f} as 0.00085.

### Example 7: Segmented High-Temperature Curing (70/40 5 min + 140 20 min)

Preparation of cycloolefin composition: 790 g of dicyclopentadiene, 200 g of tricyclopentadiene (TCPD), and 10 g of tetracyclopentadiene (TeCPD) were mixed, heated to 125°C under a nitrogen atmosphere, stirred for 12 h, and cooled to room temperature for later use;
Liquid ruthenium catalyst: 0.66 g of a liquid ruthenium alkylidene catalyst of Formula IV;
High-frequency low-dielectric material molding: The molding was carried out using the VARI process. Before the molding was started, the mold was preheated, with one side of the mold at 70°C and the other side at 40°C. Then, the mold cavity was evacuated to -0.095 MPaG. The pressure was kept at this level during the filling process. 1000 g of cycloolefin composition and 0.66 g of liquid ruthenium catalyst were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump and cured for 5 min; once the resin mixture filled up the mold, the vacuum valve was switched off immediately.; then, the temperatures on both sides of the mold were rapidly increased to 140°C, and curing was continued for 20 min; after cooling to 80°C or below, the mold was demolded to obtain a sample.
Performance testing of the molded material: The HDT of the obtained material was 158°C, and the Tg was 189°C; under a test frequency of 10 GHz, the material's Dₖ was measured as 2.26 and D_{f} as 0.00073.

### Example 8: Shelf Life Test (6 Months)

Preparation of cycloolefin composition: 800 g of dicyclopentadiene, 150 g of tricyclopentadiene, 45 g of dihydrodicyclopentadiene, and 5 g of cyclohexene were mixed, heated to 125°C under a nitrogen atmosphere, stirred for 12 h, and cooled to room temperature for later use;
Preparation of liquid ruthenium catalyst composition: 0.77 g of ruthenium alkylidene catalyst of Formula VII, 45.23 g of liquid paraffin, and 4 g of chlorinated paraffin with a chlorine content of 52% were thoroughly mixed to form a homogeneous liquid ruthenium catalyst composition.

Two groups of cycloolefin resin compositions with identical formulations were prepared according to the above preparation method, and one group was sealed and stored in a cool, dry place for 6 months.

Molding of freshly prepared cycloolefin resin composition material: The molding was carried out using the RIM process. Before the molding was started, the mold was preheated, with one side of the mold at 70°C and the other side at 40°C. 1000 g of cycloolefin composition and 50 g of liquid ruthenium catalyst were thoroughly mixed and dissolved to obtain a cycloolefin resin mixture (the molar ratio of monomer to Ru was 9500:1). The cycloolefin resin mixture was pumped into a mold with a thickness of 1.5 mm using an injection pump, cured for 10 min, and demolded to obtain a sample.

Performance testing of the molded material: The HDT of the obtained material was 127°C, and the Tg was 165°C; under a test frequency of 10 GHz, the material's Dₖ was measured as 2.30 and D_{f} as 0.00089.

Molding of the cycloolefin resin composition material stored for 6 months: The molding was carried out using the RIM process. Before the molding was started, the mold was preheated, with one side of the mold at 70°C and the other side at 40°C. 1000 g of cycloolefin composition and 50 g of liquid ruthenium catalyst were thoroughly mixed and dissolved to obtain a cycloolefin resin mixture (the molar ratio of monomer to Ru was 9500:1). The cycloolefin resin mixture was pumped into a mold with a thickness of 1.5 mm using an injection pump, cured for 10 min, and demolded to obtain a sample.

Performance testing of the molded material: The HDT of the obtained material was 127°C, and the Tg was 164°C; under a test frequency of 10 GHz, the material's Dₖ was measured as 2.30 and D_{f} as 0.00088.

### Example 9: Mixed Ruthenium Catalyst Composition Initiation System (Catalyst composition of Formula IV + Formula VII + RTM)

Preparation of cycloolefin composition: 900 g of dicyclopentadiene and 100 g of tricyclopentadiene (TCPD) were mixed, heated to 60°C under a nitrogen atmosphere, stirred for 4 h, and cooled to room temperature for later use;
Liquid ruthenium catalyst composition: 0.46 g of a liquid ruthenium alkylidene catalyst of Formula IV (Mw = 939.19 g/mol) and 0.25 g of ruthenium alkylidene catalyst of Formula VII (Mw: 1017.3 g/mol) were uniformly mixed to obtain the liquid ruthenium catalyst composition;
High-frequency low-dielectric material molding: The molding was carried out using the RTM process. Before the molding was started, the mold was preheated, with one side of the mold at 70°C and the other side at 40°C. 1000 g of cycloolefin composition and 0.71 g of liquid ruthenium catalyst composition were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump. After curing for 5 min, the molded sample was demolded.
Performance testing of the molded material: The HDT of the obtained material was 137°C, and the Tg was 166°C; under a test frequency of 10 GHz, the material's Dₖ was measured as 2.29 and D_{f} as 0.00072.

### Example 10: Upper limit of Ru Catalyst Amount (7500:1)

Preparation of cycloolefin composition: 900 g of dicyclopentadiene and 100 g of tricyclopentadiene (TCPD) were mixed, heated to 60°C under a nitrogen atmosphere, stirred for 4 h, and cooled to room temperature for later use;
Liquid ruthenium catalyst: 0.91 g of a liquid ruthenium alkylidene catalyst of Formula IV (Mw = 939.19 g/mol);
High-frequency low-dielectric material molding: The molding was carried out using the RTM process. Before the molding was started, the mold was preheated, with one side of the mold at 70°C and the other side at 40°C. 1000 g of cycloolefin composition and 0.91 g of liquid ruthenium catalyst composition were thoroughly mixed and dissolved to obtain a cycloolefin resin mixture (the molar ratio of monomer to Ru was 7500:1). The cycloolefin resin mixture was pumped into a mold with a thickness of 1.5 mm using an injection pump. After curing for 5 min, the molded sample was demolded.
Performance testing of the molded material: The HDT of the obtained material was 167°C, and the Tg was 186°C; under a test frequency of 10 GHz, the material's Dₖ was measured as 2.30 and D_{f} as 0.00091.

### Example 11: Thermosetting Material Example (DCPD-TCPD-n-pentadecane + EPDM (containing 50% mineral oil)-SBS + Catalyst of Formula IV + RTM)

Preparation of cycloolefin composition: 900 g of dicyclopentadiene and 100 g of tricyclopentadiene (TCPD, 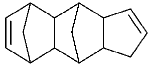 ) were mixed and added to a reaction vessel; 50 g of Keltan@ 4890C (EPDM, containing 25 g of mineral oil) and 25 g of Kraton@ D1102 (SBS) were dispersed in 50 g of n-pentadecane and then poured into the reaction vessel; under a nitrogen atmosphere, the mixture was heated to 110°C and stirred for 8 hours, then cooled to room temperature for later use;
Liquid ruthenium catalyst: 0.69 g of a liquid ruthenium alkylidene catalyst of Formula IV (Mw = 939.19 g/mol); 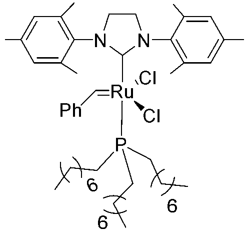 Formula IV
High-frequency low-dielectric material molding: The molding was carried out using the RTM process. Before the molding was started, the mold was preheated, with one side of the mold at 70°C and the other side at 40°C. 1125 g of cycloolefin composition and 0.69 g of liquid ruthenium catalyst were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump. After curing for 5 min, the molded sample was demolded.
Performance testing of the molded material: The HDT of the obtained material was 124°C, and the Tg was 151°C; under a test frequency of 10 GHz, the material's Dₖ was measured as 2.31 and D_{f} as 0.00079.

### Example 12: Thermosetting Material Example (DCPD-TCPD-n-Pentadecane-cetene + EPDM (containing 50% mineral oil)-POE-SEBS + Catalyst of Formula IV + RTM)

Preparation of cycloolefin composition: 900 g of dicyclopentadiene and 100 g of tricyclopentadiene (TCPD, 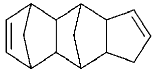 ) were mixed and added to a reaction vessel; 50 g of Keltan@ 4890C (EPDM, containing 25 g of mineral oil), 10 g of Fortify^{™} C1070D (POE), and 15 g of Kraton@ G1651 (SEBS) were dispersed in 50 g of n-pentadecane-cetene mixture (mass ratio: 85/15), and then poured into the reaction vessel; under a nitrogen atmosphere, the mixture was heated to 110°C and stirred for 8 hours, then cooled to room temperature for later use;
Liquid ruthenium catalyst: 0.69 g of a liquid ruthenium alkylidene catalyst of Formula IV (Mw = 939.19 g/mol); 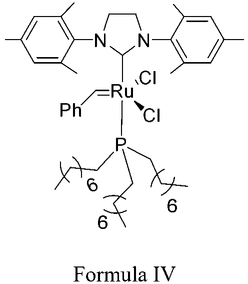
High-frequency low-dielectric material molding: The molding was carried out using the RTM process. Before the molding was started, the mold was preheated, with one side of the mold at 70°C and the other side at 40°C. 1125 g of cycloolefin composition and 0.69 g of liquid ruthenium catalyst were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump. After curing for 5 min, the molded sample was demolded.
Performance testing of the molded material: The HDT of the obtained material was 122°C, and the Tg was 149°C; under a test frequency of 10 GHz, the material's Dₖ was measured as 2.30 and D_{f} as 0.00078.

### Example 13: Thermosetting Material Example (DCPD-TCPD-n-Pentadecane + -POE-SEBS + Antioxidant 264 + Triphenylphosphine + Catalyst of Formula IV + RTM)

Preparation of cycloolefin composition: 900 g of dicyclopentadiene, 100 g of tricyclopentadiene (TCPD, 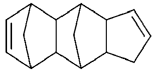 ), 1.5 g of antioxidant 264 (CAS No. 128-37-0), and 0.5 g of triphenylphosphine (TPP) were mixed and added to a reaction vessel; 20 g of Nordel^{™} 6565XFC (EPDM), 15 g of Fortify^{™} C1070D (POE), and 15 g of Kraton@ G1651 (SEBS) were dispersed in 50 g of n-pentadecane and then poured into the reaction vessel; under a nitrogen atmosphere, the mixture was heated to 110°C and stirred for 8 hours, then cooled to room temperature for later use;
Liquid ruthenium catalyst: 0.69 g of a liquid ruthenium alkylidene catalyst of Formula IV (Mw = 939.19 g/mol); 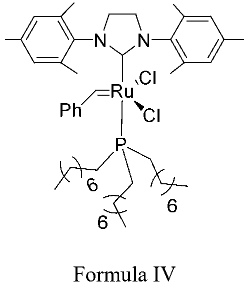
High-frequency low-dielectric material molding: The molding was carried out using the RTM process. Before the molding was started, the mold was preheated, with one side of the mold at 70°C and the other side at 40°C. 1102 g of cycloolefin composition and 0.69 g of liquid ruthenium catalyst were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump. After curing for 9 min, the molded sample was demolded.
Performance testing of the molded material: The HDT of the obtained material was 127°C, and the Tg was 152°C; under a test frequency of 10 GHz, the material's Dₖ was measured as 2.32 and D_{f} as 0.0009.

### Example 14: Preparation Process of Cycloolefin Resin-Glass Fiber Cloth Prepreg

Preparation of cycloolefin composition: 790 g of dicyclopentadiene, 200 g of tricyclopentadiene (TCPD), and 10 g of tetracyclopentadiene (TeCPD) were mixed, heated to 125°C under a nitrogen atmosphere, stirred for 12 h, and cooled to room temperature for later use;
Liquid ruthenium catalyst: 0.132 g of a liquid ruthenium alkylidene catalyst of Formula IV;
1000 g of the prepared cycloolefin composition was rapidly mixed with 0.132 g of liquid ruthenium catalyst in a mixing kettle for 15 min, and the system temperature was controlled at 2-8°C during mixing; the uniformly mixed resin mixture was then poured into an impregnation tank;
The glass fiber cloth was passed through the impregnation tank to allow the resin to adhere to the glass fiber cloth, and then the impregnated glass fiber cloth was quickly passed through a 100°C heating bridge with a total dwell time of 10 s and heated to obtain a semi-cured cycloolefin resin-glass fiber cloth prepreg.

### Example 15: Preparation of Cycloolefin Resin Copper-Clad Laminate

Four cycloolefin resin-glass fiber cloth prepregs prepared according to the method in Example 14 from the same batch and two 18 µm copper foils were stacked in the order of one copper foil, four cycloolefin resin-glass fiber cloth prepregs, and one copper foil, and then laminated under vacuum at 140°C for 1 h to form a copper-clad laminate. The four cured cycloolefin resin-glass fiber cloth sheets formed an insulating layer between the copper foils.

The prepared copper-clad laminate insulating layer material had a dielectric constant Dₖ of 2.8, a D_{f} of 0.0025, and a glass transition temperature Tg of 152°C.

### Comparative Example 1: Using G2 (G2 catalyst has extremely low solubility in cycloolefin resin and is prone to induce explosive polymerization)

Preparation of cycloolefin composition: 90 g of dicyclopentadiene and 10 g of tricyclopentadiene (TCPD) were mixed, heated to 60°C under a nitrogen atmosphere, stirred for 4 h, and cooled to room temperature for later use;

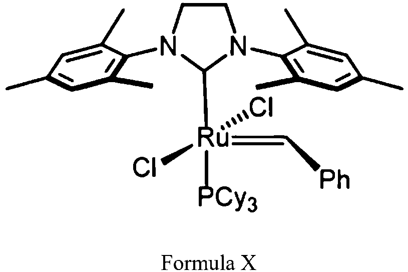

Sample preparation: 0.064 g of Grubbs second-generation catalyst (Formula X) solid was added to the cycloolefin composition and vigorously stirred at room temperature (rotation speed: 800 rpm). After stirring for 1.5 min, the catalyst powder failed to dissolve, and violent exothermic reaction occurred in some areas of the resin mixture, resulting in explosive polymerization and formation of clumps, while no reaction occurred in the remaining areas, making it impossible to produce the sample.

### Comparative Example 2: Compared with Example 1, a G2-dichloromethane solution was used.

Preparation of cycloolefin composition: 900 g of dicyclopentadiene and 100 g of tricyclopentadiene (TCPD) were mixed, heated to 60°C under a nitrogen atmosphere, stirred for 4 h, and cooled to room temperature for later use;
Preparation of ruthenium catalyst solution: 0.64 g of Grubbs second-generation catalyst was weighed and dissolved in 9.36 g of dichloromethane to form a G2-DCM solution;
Material molding: The molding was carried out using the RTM process. Before the molding was started, the mold was preheated, with one side of the mold at 70°C and the other side at 40°C. 10 g of the prepared ruthenium catalyst solution was added dropwise into 1000 g of the cycloolefin composition (the molar ratio of monomer to Ru was 10000:1), and the mixture was thoroughly stirred to form a uniform resin composition. The resulting composition was then rapidly pumped into a mold with a cavity thickness of 1.5 mm using a metering pump, cured for 5 min, and then demolded to obtain the sample.
Performance testing of the molded material: The HDT of the obtained material was 126°C, and the Tg was 161°C; under a test frequency of 10 GHz, the material's Dₖ was measured as 2.38 and D_{f} as 0.00308.

### Comparative Example 3: Compared with Example 1, a G2-toluene solution was used.

Preparation of cycloolefin composition: 900 g of dicyclopentadiene and 100 g of tricyclopentadiene (TCPD) were mixed, heated to 60°C under a nitrogen atmosphere, stirred for 4 h, and cooled to room temperature for later use;
Preparation of ruthenium catalyst solution: 0.64 g of Grubbs second-generation catalyst was weighed and dissolved in 9.36 g of toluene to form a G2-toluene solution;
Material molding: The molding was carried out using the RTM process. Before the molding was started, the mold was preheated, with one side of the mold at 70°C and the other side at 40°C. 10 g of the prepared ruthenium catalyst solution was added dropwise into 1000 g of the cycloolefin composition (the molar ratio of monomer to Ru was 10000:1), and the mixture was thoroughly stirred to form a uniform resin composition. The resulting composition was then rapidly pumped into a mold with a cavity thickness of 1.5 mm using a metering pump, cured for 5 min, and then demolded to obtain the sample.
Performance testing of the molded material: The HDT of the obtained material was 124°C, and the Tg was 160°C; under a test frequency of 10 GHz, the material's Dₖ was measured as 2.21 and D_{f} as 0.00106.

### Comparative Example 4: Compared with Example 1, a Hoveyda-toluene catalyst solution was used.

Preparation of cycloolefin composition: 900 g of dicyclopentadiene and 100 g of tricyclopentadiene (TCPD) were mixed, heated to 60°C under a nitrogen atmosphere, stirred for 4 h, and cooled to room temperature for later use;
Preparation of ruthenium catalyst solution: 0.46 g of Hoveyda catalyst solid of Formula XI was weighed and dissolved in 9.54 g of toluene to form an XI-toluene solution;

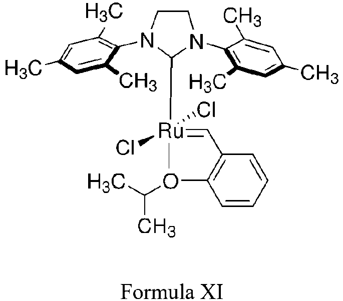

Material molding: The molding was carried out using the RTM process. Before the molding was started, the mold was preheated, with one side of the mold at 70°C and the other side at 40°C. 10 g of the prepared ruthenium catalyst solution was added dropwise into 1000 g of the cycloolefin composition (the molar ratio of monomer to Ru was 10000:1), and the mixture was thoroughly stirred to form a uniform resin composition. The resulting composition was then rapidly pumped into a mold with a cavity thickness of 1.5 mm using a metering pump, cured for 5 min, and then demolded to obtain the sample.

Performance testing of the molded material: The HDT of the obtained material was 113°C, and the Tg was 149°C; under a test frequency of 10 GHz, the material's Dₖ was measured as 2.22 and D_{f} as 0.00114.

### Comparative Example 5: Compared with Examples 5 and 6 (Catalyst concentration was too low, residual monomer)

Preparation of cycloolefin composition: 790 g of dicyclopentadiene, 200 g of tricyclopentadiene (TCPD), and 10 g of tetracyclopentadiene (TeCPD) were mixed, heated to 125°C under a nitrogen atmosphere, stirred for 12 h, and cooled to room temperature for later use;
Liquid ruthenium catalyst: 0.066 g of a liquid ruthenium alkylidene catalyst of Formula IV;
High-frequency low-dielectric material molding: The molding was carried out using the VARI process. Before the molding was started, the mold was preheated, with one side of the mold at 80°C and the other side at 45°C. Then, the mold cavity was evacuated to -0.09 MPaG. The pressure was kept at this level during the filling process. 1000 g of cycloolefin composition and 0.066 g of liquid ruthenium catalyst were thoroughly mixed and dissolved to obtain a cycloolefin resin mixture (the molar ratio of monomer to Ru was 80000:1). The cycloolefin resin mixture was pumped into a mold with a thickness of 1.5 mm using an injection pump. Once the resin mixture filled up the mold, the vacuum valve was switched off immediately. After curing for 30 min, the molded sample was demolded.
Performance testing of the molded material: The Tg of the obtained material was 65°C; under a test frequency of 10 GHz, the material's Dₖ was measured as 2.41 and D_{f} as 0.00589.

### Comparative Example 6.1: Compared with Examples 5 and 6 (Catalyst concentration was too high)

Preparation of cycloolefin composition: 790 g of dicyclopentadiene, 200 g of tricyclopentadiene (TCPD), and 10 g of tetracyclopentadiene (TeCPD) were mixed, heated to 125°C under a nitrogen atmosphere, stirred for 12 h, and cooled to room temperature for later use;
Liquid ruthenium catalyst: 1.32 g of a liquid ruthenium alkylidene catalyst of Formula IV;
High-frequency low-dielectric material molding: The molding was carried out using the VARI process. Before the molding was started, the mold was preheated, with one side of the mold at 60°C and the other side at 40°C. Then, the mold cavity was evacuated to -0.095 MPaG. The pressure was kept at this level during the filling process. 1000 g of cycloolefin composition and 1.32 g of liquid ruthenium catalyst were thoroughly mixed and dissolved to obtain a cycloolefin resin mixture (the molar ratio of monomer to Ru was 5000:1). The cycloolefin resin mixture was pumped into a mold with a thickness of 1.5 mm using an injection pump. Once the resin mixture filled up the mold, the vacuum valve was switched off immediately. After curing for 30 min, the molded sample was demolded.
Performance testing of the molded material: The heat deflection temperature HDT of the obtained material was 120°C, and the Tg was 144°C; under a test frequency of 10 GHz, the material's Dₖ was measured as 2.29 and D_{f} as 0.00109.

### Comparative Example 6.2: Compared with Examples 5, 6, and 10 (Catalyst concentration was too high)

Preparation of cycloolefin composition: 790 g of dicyclopentadiene, 200 g of tricyclopentadiene (TCPD), and 10 g of tetracyclopentadiene (TeCPD) were mixed, heated to 125°C under a nitrogen atmosphere, stirred for 12 h, and cooled to room temperature for later use;
Liquid ruthenium catalyst: 1.02 g of a liquid ruthenium alkylidene catalyst of Formula IV;
High-frequency low-dielectric material molding: The molding was carried out using the VARI process. Before the molding was started, the mold was preheated, with one side of the mold at 60°C and the other side at 40°C. Then, the mold cavity was evacuated to -0.09 MPaG. The pressure was kept at this level during the filling process. 1000 g of cycloolefin composition and 1.02 g of liquid ruthenium catalyst were thoroughly mixed and dissolved to obtain a cycloolefin resin mixture (the molar ratio of monomer to Ru was 6500:1). The cycloolefin resin mixture was pumped into a mold with a thickness of 1.5 mm using an injection pump. Once the resin mixture filled up the mold, the vacuum valve was switched off immediately. After curing for 30 min, the molded sample was demolded.
Performance testing of the molded material: The heat deflection temperature HDT of the obtained material was 122°C, and the Tg was 151°C; under a test frequency of 10 GHz, the material's Dₖ was measured as 2.29 and D_{f} as 0.00102.

### Comparative Example 7: Compared with Example 1 (The molding temperature was too high, and the time was too long, resulting in thermal aging)

Preparation of cycloolefin composition: 900 g of dicyclopentadiene and 100 g of tricyclopentadiene (TCPD) were mixed, heated to 60°C under a nitrogen atmosphere, stirred for 4 h, and cooled to room temperature for later use;
Liquid ruthenium catalyst: 0.69 g of a liquid ruthenium alkylidene catalyst of Formula IV;
Material molding: The molding was carried out using the RTM process. 1000 g of cycloolefin composition and 0.69 g of liquid ruthenium catalyst were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump, and the temperature was rapidly increased to 160°C on one side of the mold and 130°C on the other side, followed by curing for 180 min. After the curing was completed and the mold temperature was reduced to 80°C, the product was demolded.
Performance testing of the molded material: The HDT of the obtained material was 147°C, and the Tg was 176°C; under a test frequency of 10 GHz, the material's Dₖ was measured as 2.32 and D_{f} as 0.00264.

### Comparative Example 8: Compared with Example 1 (the molding temperature was too low, residual monomer)

Preparation of cycloolefin composition: 900 g of dicyclopentadiene and 100 g of tricyclopentadiene (TCPD) were mixed, heated to 60°C under a nitrogen atmosphere, stirred for 4 h, and cooled to room temperature for later use;
Liquid ruthenium catalyst: 0.69 g of a liquid ruthenium alkylidene catalyst of Formula IV;
Material molding: The molding was carried out using the RTM process. Before the molding was started, the mold was preheated, with one side of the mold at 35°C and the other side at 35°C. 1000 g of cycloolefin composition and 0.69 g of liquid ruthenium catalyst were thoroughly mixed and dissolved to obtain a cycloolefin resin mixture (the molar ratio of monomer to Ru was 10000:1). The cycloolefin resin mixture was pumped into a mold with a thickness of 1.5 mm using an injection pump. After curing for 120 min, the molded sample was demolded.
Performance testing of the molded material: The HDT of the obtained material was 111°C, and the Tg was 128°C; under a test frequency of 10 GHz, the material's Dₖ was measured as 2.39 and D_{f} as 0.00282.

Comparison description:
(1) Comparison between Example 1 and Comparative Example 1 demonstrates that the liquid ruthenium catalyst/catalyst composition in the resin composition disclosed in the present disclosure exhibits better solubility in cycloolefin compositions compared to conventional solid catalysts; comparison between Example 1 and Comparative Examples 2-4 demonstrates that the material obtained after mixing and curing the liquid ruthenium catalyst composition disclosed in the present disclosure with the disclosed cycloolefin composition exhibits significantly lower D_{f} values (D_{f} < 0.001) compared to solutions of conventional Grubbs second-generation catalyst and Hoveyda catalyst;
(2) The comparison results of Examples 5 and 6 with Comparative Examples 5 and 6 indicate that when the catalyst content in the cycloolefin resin composition is too low, the D_{f} value of the material increases rapidly after curing due to the presence of residual monomers; when the catalyst content in the cycloolefin resin composition is too high, the D_{f} value of the material increases after curing due to the elevated concentration of residual metal ions, failing to meet relevant application requirements;
(3) The comparison results of Example 1 with Comparative Example 7 indicate that after long-time high-temperature curing of the cycloolefin resin composition, the heat resistance of the material improves, but the dielectric properties, particularly the D_{f} performance, are severely deteriorated, failing to meet relevant application requirements;
(4) The comparison results of Example 1 with Comparative Example 8 indicate that when the curing temperature of the cycloolefin resin composition is too low, even after prolonged curing, the dielectric properties of the material still fail to meet relevant application requirements; (5) The materials obtained by mixing and curing one of the cycloolefins in Examples 1-13 or cycloolefins with a liquid ruthenium catalyst/catalyst composition all achieve significantly low D_{f} values (< 0.001) and Dₖ values (< 2.5) at a test frequency of 10 GHz.

## Claims

1. A use of a cycloolefin resin composition M1 in the preparation of a substrate material for a high-frequency and high-speed information transmission device, wherein the cycloolefin resin composition M1 comprises component A and component B, wherein the component A is cycloolefin, the component B is a ruthenium alkylidene compound of Formula I and/or Formula II or a salt thereof, and the molar ratio of Ru in the component B to the monomer of cycloolefin in the component A is 1:(7500-60000), 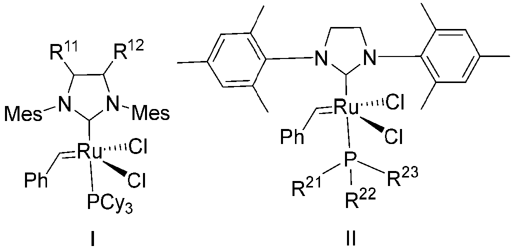 wherein
R¹¹ and R¹² are each independently C₄-C₁₈ alkyl or C₄-C₁₈ alkyl substituted by R¹⁻¹;
R¹⁻¹ is C₆-C₁₀ aryl;
R²¹, R²², and R²³ are each independently C₆-C₁₈ alkyl.

2. The use of the cycloolefin resin composition M1 in the preparation of the substrate material for the high-frequency and high-speed information transmission device according to claim 1, wherein the use satisfies one or more of the following conditions:
(1) the substrate material for the high-frequency and high-speed information transmission device has a dielectric loss of < 0.001 at a frequency of ≥ 1 GHz, for example, a dielectric loss of 0.00067, 0.00069, 0.00071, 0.00072, 0.00073, 0.00075, 0.00077, 0.00078, 0.00079, 0.00085, 0.00086, 0.00087, 0.00088, 0.00089, 0.0009, or 0.00091; the frequency of ≥ 1 GHz is, for example, 1-12 GHz, further for example, 10 GHz;
(2) the substrate material for the high-frequency and high-speed information transmission device has a dielectric constant of < 2.5 at a frequency of ≥ 1 GHz, for example, a dielectric constant of 2.23, 2.26, 2.27, 2.28, 2.29, 2.30, 2.31, or 2.32; the frequency of ≥ 1 GHz is, for example, 1-12 GHz, further for example, 10 GHz;
(3) the substrate material for the high-frequency and high-speed information transmission device has a glass transition temperature of ≥ 135°C, for example, 138°C, 149°C, 152°C, 155°C, 157°C, 160°C, 162°C, 164°C, 165°C, 166°C, 175°C, 177°C, 186°C, 189°C, or 190°C;
(4) the substrate material for the high-frequency and high-speed information transmission device has a heat deflection temperature of ≥ 110°C, for example, 115°C, 117°C, 119°C, 122°C, 126°C, 127°C, 134°C, 137°C, 142°C, 144°C, 147°C, 158°C, or 167°C;
(5) in the cycloolefin resin composition M1, the mass percentage of the component A is 80% or more, but less than 100%;
(6) the molar ratio of Ru in the component B to the monomer of cycloolefin in the component A is 1:(7500-50000), for example, 1:7500, 1:9500, 1:10000, 1:15000, or 1:50000;
(7) the component A is a single type of cycloolefin or a mixture of multiple cycloolefins; the cycloolefin contains only C and H elements and may be substituted by one or more R^{A}, wherein each R^{A} is independently F, C₁-C₁₈ alkyl, C₂-C₁₈ alkenyl, C₆-C₁₀ aryl, alkoxy with a carbon chain length of C₂-C₁₈, -C(=O)OC₂-C₁₈, or - OC(=O)C₂-C₁₈;
preferably, the component A is a single type of cycloolefin or a mixture of multiple cycloolefins, the component A at least comprises cycloolefin S1, the cycloolefin S1 contains only C and H elements and comprises the following structural moieties: 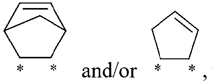 wherein the structural moieties are connected to other parts of the molecule via a carbon atom marked with "*"; the cycloolefin S1 may be substituted by one or more R^{A}, wherein each R^{A} is independently F, C₁-C₁₈ alkyl, C₂-C₁₈ alkenyl, C₆-C₁₀ aryl, C₂-C₁₈ alkoxy, -C(=O)OC₂-C₁₈, or -OC(=O)C₂-C₁₈;
more preferably, the component A is one or more selected from tetracyclododecene, cyclopentadiene polymer, 5-ethylidene-2-norbornene, cyclohexene, cycloheptene, cyclooctene, and cycloolefin having a structure of Formula A-1 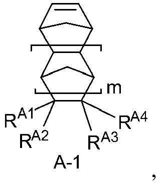 wherein in Formula A-1, m is 0, 1, or 2, and R^{A1}, R^{A2}, R^{A3}, and R^{A4} are each independently H, F, C₁-C₁₈ alkyl, C₂-C₁₈ alkenyl, C₆-C₁₀ aryl, C₂-C₁₈ alkoxy, -C(=O)OC₂-C₁₈, or - OC(=O)C₂-C₁₈; the cyclopentadiene polymer is, for example, one or more selected from dicyclopentadiene, tricyclopentadiene, tetracyclopentadiene, and dihydrodicyclopentadiene; the dihydrodicyclopentadiene is, for example, 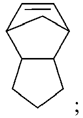
(8) in the ruthenium alkylidene compound of Formula I, in R¹¹ and R¹², the C₄-C₁₈ alkyl and the C₄-C₁₈ alkyl in the C₄-C₁₈ alkyl substituted by R¹⁻¹ are each independently C₄-C₁₈ linear alkyl, for example, -(CH₂)₃CH₃, -(CH₂)₅CH₃, -(CH₂)₉CH₃, -(CH₂)₁₃CH₃, or -(CH₂)₁₇CH₃;
(9) in the ruthenium alkylidene compound of Formula I, in R¹⁻¹, the C₆-C₁₀ aryl is phenyl or naphthyl, for example, phenyl;
(10) in the ruthenium alkylidene compound of Formula II, in R²¹, R²², and R²³, each C₆-C₁₈ alkyl is independently C₆-C₁₀ alkyl, preferably C₆ alkyl, C₈ alkyl, or C₁₀ alkyl;
preferably, the ruthenium alkylidene compound of Formula II is one or more selected from the following compounds: 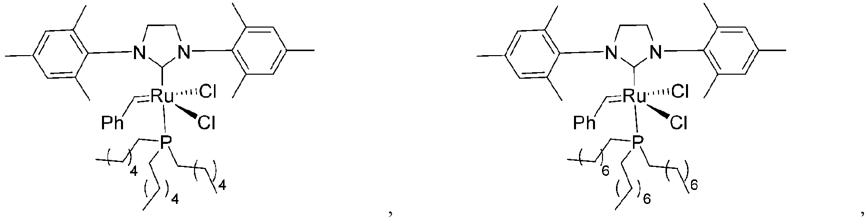 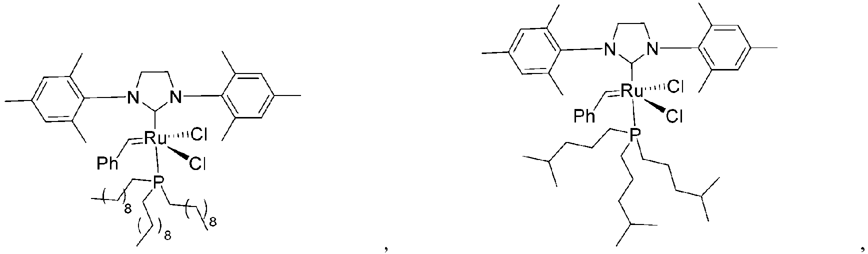 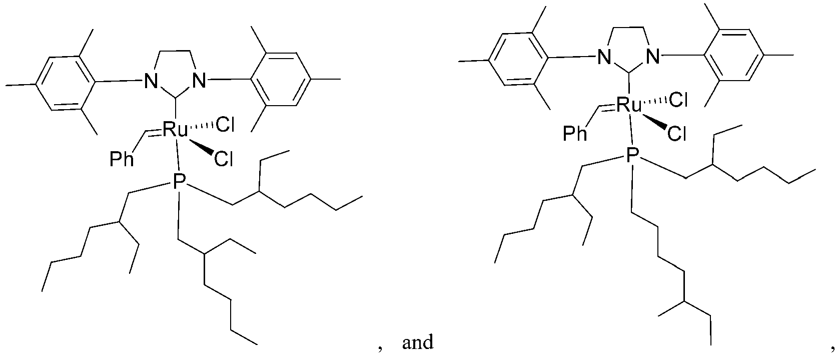 for example,

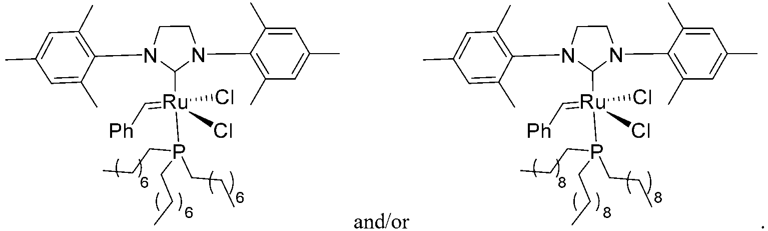

3. The use of the cycloolefin resin composition M1 in the preparation of the substrate material for the high-frequency and high-speed information transmission device according to claim 1, wherein the use satisfies one or more of the following conditions:
(1) the component A is any one of the following schemes:
Scheme A1: the component A is tetracyclododecene;
Scheme A2: the component A is dihydrodicyclopentadiene;
Scheme A3: in the component A, the mass percentage of dicyclopentadiene is 70% to 100%, for example, 79%, 80%, 90%, or 98%;
Scheme A4: in the component A, the mass percentage of tricyclopentadiene is 0% to 30%, for example, 10%, 15%, or 20%;
(2) in the ruthenium alkylidene compound of Formula I, R¹¹ and R¹² are each independently C₄-C₁₈ alkyl or C₄-C₁₈ alkyl substituted by one phenyl group;
preferably, the ruthenium alkylidene compound of Formula I is one or more selected from the following compounds: 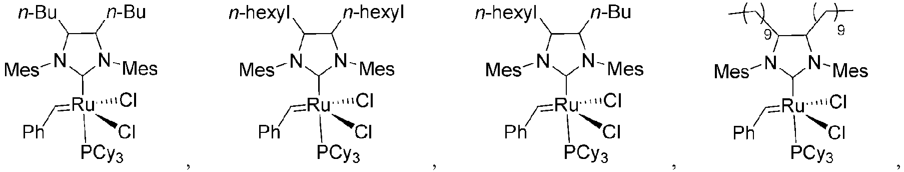 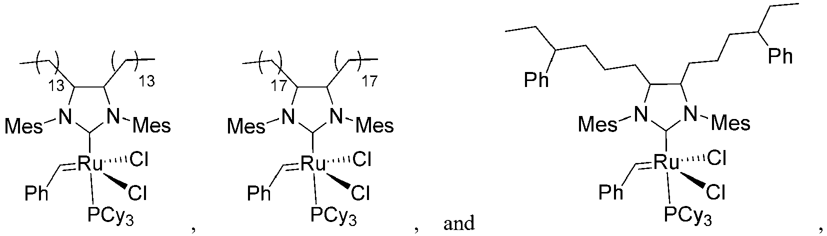 for example,

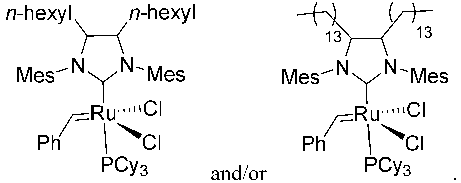

4. The use of the cycloolefin resin composition M1 in the preparation of the substrate material for the high-frequency and high-speed information transmission device according to claim 1, wherein the use satisfies one or more of the following conditions:
(1) the component A comprises 70% to 100% by mass of dicyclopentadiene and 0% to 30% by mass of tricyclopentadiene;
preferably, the component A is any one of the following schemes:
Scheme B1: the component A consists of the following components: 85% to 95% by mass of dicyclopentadiene and 5% to 15% by mass of tricyclopentadiene;
Scheme B2: the component A consists of the following components: 90% to 100% by mass of dicyclopentadiene and 0% to 10% by mass of 5-ethylidene-2-norbornene;
Scheme B3: the component A consists of the following components: 70% to 90% by mass of dicyclopentadiene, 10% to 30% by mass of tricyclopentadiene, and 0% to 5% by mass of tetracyclopentadiene;
Scheme B4: the component A consists of the following components: 70% to 90% by mass of dicyclopentadiene, 10% to 20% by mass of tricyclopentadiene, 0% to 10% by mass of dihydrodicyclopentadiene, and 0% to 5% by mass of cyclohexene;
more preferably, the component A is any one of the following schemes:
Scheme 1: the component A consists of 90% by mass of dicyclopentadiene and 10% by mass of tricyclopentadiene;
Scheme 2: the component A consists of 98% by mass of dicyclopentadiene and 2% by mass of 5-ethylidene-2-norbomene;
Scheme 3: the component A consists of 79% by mass of dicyclopentadiene, 20% by mass of tricyclopentadiene, and 1% by mass of tetracyclopentadiene;
Scheme 4: the component A consists of 80% by mass of dicyclopentadiene, 15% by mass of tricyclopentadiene, 4.5% by mass of dihydrodicyclopentadiene, and 0.5% by mass of cyclohexene;
(2) the substrate material for the high-frequency and high-speed information transmission device is a copper-clad laminate;
(3) the component B is any one of the following schemes:
Scheme D1: the component B is a ruthenium alkylidene compound of Formula I;
Scheme D2: the component B is a ruthenium alkylidene compound of Formula II;
Scheme D3: the component B consists of a ruthenium alkylidene compound of Formula I and a ruthenium alkylidene compound of Formula II, for example, 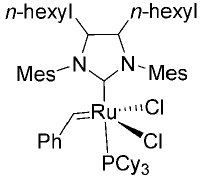 and 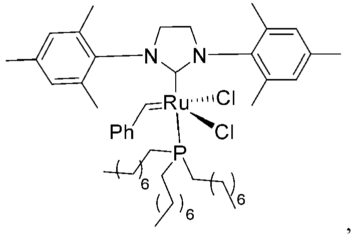 wherein the molar ratio of the ruthenium alkylidene compound of Formula I to the ruthenium alkylidene compound of Formula II is, for example, 1:(1.5-5), further for example, 1:2.

5. The use of the cycloolefin resin composition M1 in the preparation of the substrate material for the high-frequency and high-speed information transmission device according to claim 1, wherein the cycloolefin resin composition M1 further comprises component C and/or component D, wherein
the component C is one or more selected from solid paraffin, liquid paraffin, and chlorinated paraffin with a chlorine content of 5 wt% to 65 wt%, for example, liquid paraffin, chlorinated paraffin with a chlorine content of 5 wt% to 65 wt%, or a mixture of liquid paraffin and chlorinated paraffin with a chlorine content of 5 wt% to 65 wt%, wherein in the mixture, the mass ratio of the liquid paraffin to the chlorinated paraffin with a chlorine content of 5 wt% to 65 wt% is, for example, (10-20):1, further for example, 11:1; and the component D is one or more selected from thermoplastic resin, linear or branched chain olefin with a carbon chain length of C₁₂ or more, linear or branched chain alkane with a carbon chain length of C₁₂ or more, solid paraffin, and mineral oil; and the thermoplastic resin, chain olefin, and chain alkane contain only C and H elements;
preferably, the thermoplastic resin is one or more selected from ethylene-propylene rubber (EP), ethylene-propylene-diene monomer rubber (EPDM), polyolefin elastomer (POE), liquid butyl rubber (LBR), styrene-butadiene rubber (SBR), hydrogenated styrene-butadiene rubber (SEBS), and styrene-butadiene-styrene block copolymer (SBS); preferably, the thermoplastic resin is added with an additive, wherein the additive is an organic phosphorus compound and/or an antioxidant, the organic phosphorus compound is, for example, one or more selected from triphenylphosphine, tricyclohexylphosphine, trioctylphosphine, and tributylphosphine, and the antioxidant is preferably a hindered phenol antioxidant, for example, one or more selected from an antioxidant 264, an antioxidant 1010, and an antioxidant 168; preferably, based on the total mass of component A and component D, the mass percentage of the additive is 0-0.5 wt%, for example, 0-0.3 wt%;
preferably, the linear or branched chain alkane with a carbon chain length of C₁₂ or more is n-pentadecane;
preferably, the ratio of the total mass of the component C and the component B to the mass of the component A is 1:(15-200), for example, 1:(15-55), further for example, 1:(20-50);
preferably, based on the total mass of component A and component D, the mass percentage of the component D is 0-20 wt%, preferably 0-10 wt%.

6. The use of the cycloolefin resin composition M1 in the preparation of the substrate material for the high-frequency and high-speed information transmission device according to claim 5, wherein the use satisfies one or more of the following conditions:
(1) the component C is liquid paraffin and/or chlorinated paraffin with a chlorine content of 5 wt% to 65 wt%, and the mass ratio of the component C to the component B is (15-70):1, for example, 21:1, 28:1, or 64:1;
preferably, the component C is any one of the following schemes:
Scheme E1: the component C is liquid paraffin, and the mass ratio of the component C to the component B is (60-70):1, for example, 64:1;
Scheme E2: the component C is chlorinated paraffin with a chlorine content of 5 wt% to 65 wt%, and the mass ratio of the component C to the component B is (15-35):1, for example, 21:1 or 28:1;
Scheme E3: the component C is a mixture of liquid paraffin and chlorinated paraffin with a chlorine content of 5 wt% to 65 wt%, wherein in the mixture, the mass ratio of the liquid paraffin to the chlorinated paraffin with a chlorine content of 5 wt% to 65 wt% is, for example, (10-20):1, for example, 11:1; and the mass ratio of the component C to the component B is (60-70):1, for example, 64:1;
(2) the chlorinated paraffin with a chlorine content of 5 wt% to 65 wt% is chlorinated paraffin with a chlorine content of 5 wt% to 52 wt%.

7. The use of the cycloolefin resin composition M1 in the preparation of the substrate material for the high-frequency and high-speed information transmission device according to claim 1, wherein
the cycloolefin resin composition M1 is any one of the following schemes:
Scheme F1: the cycloolefin resin composition M1 consists of the component A according to any one of claims 1-4 and the component B according to any one of claims 1-4;
Scheme F2: the cycloolefin resin composition M1 consists of the component A according to any one of claims 1-4, the component B according to any one of claims 1-4, and the component C according to any one of claims 5-6;
Scheme F3: the cycloolefin resin composition M1 consists of the component A according to any one of claims 1-4, the component B according to any one of claims 1-4, and the component D according to any one of claims 5-6;
Scheme F4: the cycloolefin resin composition M1 consists of the component A according to any one of claims 1-4, the component B according to any one of claims 1-4, the component C according to any one of claims 5-6, and the component D according to any one of claims 5-6;
preferably, the cycloolefin resin composition M1 consists of components according to any of the following schemes:
Scheme C1: component A and component B,
the component A consists of dicyclopentadiene and tricyclopentadiene, wherein the mass percentage of dicyclopentadiene in the component A is 90%, and the mass percentage of tricyclopentadiene in the component A is 10%;
the component B is 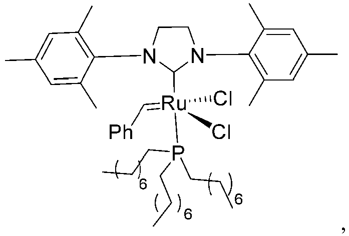
the molar ratio of Ru in the component B to the monomer of cycloolefin in the component A is 1:10000;
Scheme C2: component A and component B,
the component A is tetracyclododecene;
the component B is 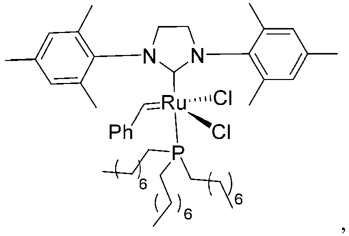
the molar ratio of Ru in the component B to the monomer of cycloolefin in the component A is 1:15000;
Scheme C3: component A and component B,
the component A is dihydrodicyclopentadiene;
the component B is 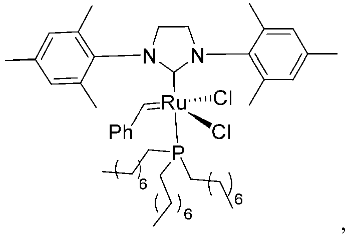
the molar ratio of Ru in the component B to the monomer of cycloolefin in the component A is 1:15000;
Scheme C4: component A, component B, and component C,
the component A consists of dicyclopentadiene and 5-ethylidene-2-norbornene, wherein the mass percentage of dicyclopentadiene in the component A is 98%, and the mass percentage of 5-ethylidene-2-norbornene in the component A is 2%;
the component B is 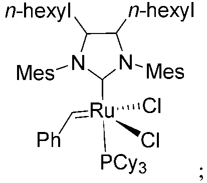
the molar ratio of Ru in the component B to the monomer of cycloolefin in the component A is 1:10000;
the component C is liquid paraffin;
the ratio of the total mass of the component C and the component B to the mass of the component A is 1:20;
Scheme C5: component A, component B, and component C
the component A consists of dicyclopentadiene and tricyclopentadiene, wherein the mass percentage of dicyclopentadiene in the component A is 90%, and the mass percentage of tricyclopentadiene in the component A is 10%;
the component B is 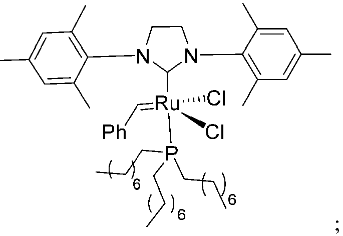 the molar ratio of Ru in the component B to the monomer of cycloolefin in the component A is 1:10000;
the component C is chlorinated paraffin with a chlorine content of 5%;
the ratio of the total mass of the component C and the component B to the mass of the component A is 1:50;
Scheme C6: component A, component B, and component C
the component A consists of dicyclopentadiene and tricyclopentadiene, wherein the mass percentage of dicyclopentadiene in the component A is 90%, and the mass percentage of tricyclopentadiene in the component A is 10%;
the component B is 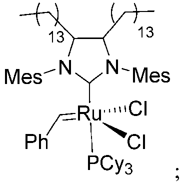
the molar ratio of Ru in the component B to the monomer of cycloolefin in the component A is 1:10000;
the component C is chlorinated paraffin with a chlorine content of 5%;
the ratio of the total mass of the component C and the component B to the mass of the component A is 1:50;
Scheme C7: component A and component B
the component A consists of dicyclopentadiene, tricyclopentadiene, and tetracyclopentadiene, wherein the mass percentage of dicyclopentadiene in the component A is 79%, the mass percentage of tricyclopentadiene in the component A is 20%, and the mass percentage of tetracyclopentadiene in the component A is 1%;
the component B is 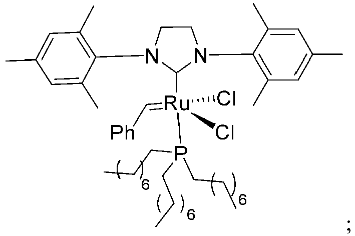
the molar ratio of Ru in the component B to the monomer of cycloolefin in the component A is 1:10000;
Scheme C8: component A, component B, and component C
the component A consists of dicyclopentadiene, tricyclopentadiene, and tetracyclopentadiene, wherein the mass percentage of dicyclopentadiene in the component A is 79%, the mass percentage of tricyclopentadiene in the component A is 20%, and the mass percentage of tetracyclopentadiene in the component A is 1%;
the component B is 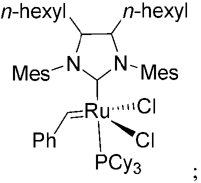
the molar ratio of Ru in the component B to the monomer of cycloolefin in the component A is 1:10000;
the component C is liquid paraffin;
the ratio of the total mass of the component C and the component B to the mass of the component A is 1:200;
Scheme C9: component A and component B
the component A consists of dicyclopentadiene, tricyclopentadiene, and tetracyclopentadiene, wherein the mass percentage of dicyclopentadiene in the component A is 79%, the mass percentage of tricyclopentadiene in the component A is 20%, and the mass percentage of tetracyclopentadiene in the component A is 1%;
the component B is 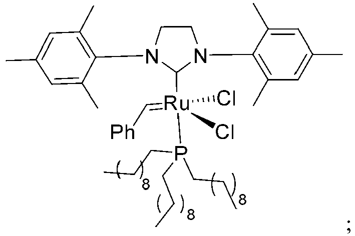
the molar ratio of Ru in the component B to the monomer of cycloolefin in the component A is 1:10000;
Scheme C10: component A and component B
the component A consists of dicyclopentadiene, tricyclopentadiene, and tetracyclopentadiene, wherein the mass percentage of dicyclopentadiene in the component A is 79%, the mass percentage of tricyclopentadiene in the component A is 20%, and the mass percentage of tetracyclopentadiene in the component A is 1%;
the component B is 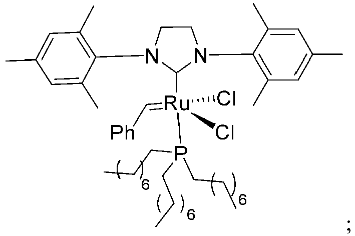
the molar ratio of Ru in the component B to the monomer of cycloolefin in the component A is 1:50000;
Scheme C11: component A, component B, and component C
the component A consists of dicyclopentadiene, tricyclopentadiene, dihydrodicyclopentadiene, and cyclohexene, wherein the mass percentage of dicyclopentadiene in the component A is 80%, the mass percentage of tricyclopentadiene in the component A is 15%, the mass percentage of dihydrodicyclopentadiene in the component A is 4.5%, and the mass percentage of cyclohexene in the component A is 0.5%;
the component B is 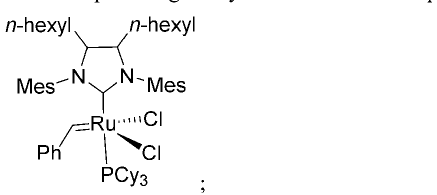
the molar ratio of Ru in the component B to the monomer of cycloolefin in the component A is 1:9500;
the component C consists of liquid paraffin and chlorinated paraffin with a chlorine content of 52 wt%, wherein the mass ratio of liquid paraffin to chlorinated paraffin with a chlorine content of 52 wt% is 11:1;
the ratio of the total mass of the component C and the component B to the mass of the component A is 1:20;
Scheme C12: component A and component B
the component A consists of dicyclopentadiene and tricyclopentadiene, wherein the mass percentage of dicyclopentadiene in the component A is 90%, and the mass percentage of tricyclopentadiene in the component A is 10%;
the component B consists of 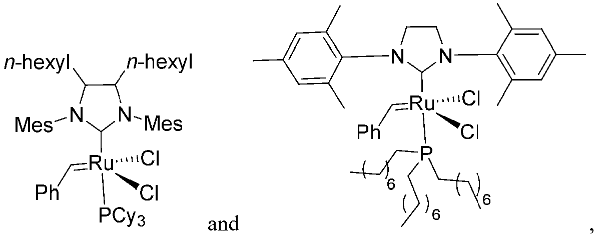 wherein the molar ratio of 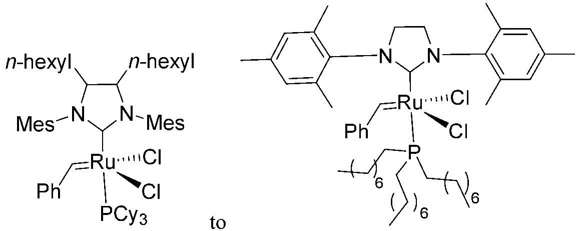 is 1:2;
the molar ratio of Ru in the component B to the monomer of cycloolefin in the component A is 1:10000;
Scheme C13: component A and component B
the component A consists of dicyclopentadiene and tricyclopentadiene, wherein the mass percentage of dicyclopentadiene in the component A is 90%, and the mass percentage of tricyclopentadiene in the component A is 10%;
the component B is 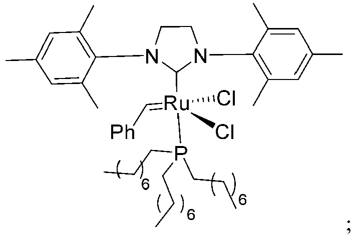
the molar ratio of Ru in the component B to the monomer of cycloolefin in the component A is 1:7500;
Scheme C14: component A, component B, and component D
the component A consists of dicyclopentadiene and tricyclopentadiene, wherein the mass percentage of dicyclopentadiene in the component A is 90%, and the mass percentage of tricyclopentadiene in the component A is 10%;
the component B is 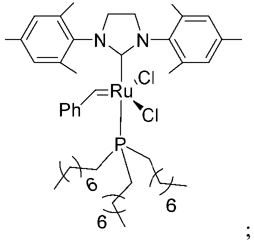
the molar ratio of Ru in the component B to the monomer of cycloolefin in the component A is 1:10000;
the component D is a mixture of n-pentadecane, EPDM, SBS, and mineral oil;
based on the total mass of the component A and the component D, in the component D, the mass percentage of n-pentadecane is 4-5%, and the mass percentages of EPDM, SBS, and mineral oil are independently 2-3%;
Scheme C15: component A, component B, and component D
the component A consists of dicyclopentadiene and tricyclopentadiene, wherein the mass percentage of dicyclopentadiene in the component A is 90%, and the mass percentage of tricyclopentadiene in the component A is 10%;
the component B is 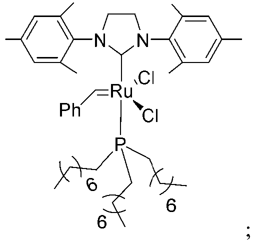
the molar ratio of Ru in the component B to the monomer of cycloolefin in the component A is 1:10000;
the component D is a mixture of n-pentadecane, cetene, EPDM, SEBS, POE, and mineral oil;
based on the total mass of the component A and the component D, the mass percentage of n-pentadecane is 2-4%, the mass percentage of cetene is 0.3-1%, the mass percentage of EPDM is 2-3%, the mass percentage of SEBS is 0.3-1%, the mass percentage of POE is 0.5-1.2%, and the mass percentage of mineral oil is independently 2-3%;
Scheme C16: component A, component B, and component D
the component A consists of dicyclopentadiene and tricyclopentadiene, wherein the mass percentage of dicyclopentadiene in the component A is 90%, and the mass percentage of tricyclopentadiene in the component A is 10%;
the component B is 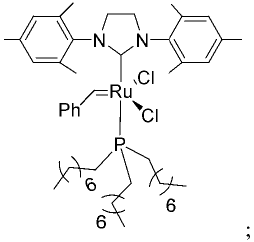
the component D is a mixture of an antioxidant 264, triphenylphosphine, n-pentadecane, EPDM, SEBS, and POE;
based on the total mass of the component A and the component D, the mass percentage of the antioxidant 264 is 0.1-0.2%, the mass percentage of triphenylphosphine is 0.02-0.1%, the mass percentage of n-pentadecane is 4-5%, the mass percentage of EPDM is 1-2%, the mass percentage of SEBS is 1-2%, and the mass percentage of POE is 1-2%.

8. A cycloolefin resin composition, wherein the cycloolefin resin composition is a cycloolefin resin composition M1, a cycloolefin resin composition M2, a cycloolefin resin composition M3, a cycloolefin resin composition M4, or a cycloolefin resin composition M5 as follows:
cycloolefin resin composition M1: which is the cycloolefin resin composition M1 according to any one of claims 1-7, and in the cycloolefin resin composition M1, the mass percentage of the component A is 80% or more, but less than 100%;
cycloolefin resin composition M2: consisting of the component A according to any one of claims 1-4 and the component B according to any one of claims 1-4;
cycloolefin resin composition M3: consisting of the component A according to any one of claims 1-4, the component B according to any one of claims 1-4, and the component C according to any one of claims 5-6;
cycloolefin resin composition M4: consisting of the component A according to any one of claims 1-4, the component B according to any one of claims 1-4, and the component D according to any one of claims 5-6;
cycloolefin resin composition M5: consisting of the component A according to any one of claims 1-4, the component B according to any one of claims 1-4, the component C according to any one of claims 5-6, and the component D according to any one of claims 5-6.

9. A cycloolefin resin material, wherein the cycloolefin resin material is prepared using the cycloolefin resin composition M1, the cycloolefin resin composition M2, the cycloolefin resin composition M3, the cycloolefin resin composition M4, or the cycloolefin resin composition M5 according to claim 8 as a raw material;
preferably, the cycloolefin resin material satisfies one or more of the following conditions:
(1) the cycloolefin resin material has a dielectric loss of < 0.001 at a frequency of ≥ 1 GHz, for example, a dielectric loss of 0.00067, 0.00069, 0.00071, 0.00072, 0.00073, 0.00075, 0.00077, 0.00078, 0.00079, 0.00085, 0.00086, 0.00087, 0.00088, 0.00089, 0.0009, or 0.00091; the frequency of ≥ 1 GHz is, for example, 1-12 GHz, further for example, 10 GHz;
(2) the cycloolefin resin material has a dielectric constant of < 2.5 at a frequency of ≥ 1 GHz, for example, a dielectric constant of 2.23, 2.26, 2.27, 2.28, 2.29, 2.30, 2.31, or 2.32; the frequency of ≥ 1 GHz is, for example, 1-12 GHz, further for example, 10 GHz;
(3) the cycloolefin resin material has a glass transition temperature of ≥ 135°C, for example, 138°C, 149°C, 152°C, 155°C, 157°C, 160°C, 162°C, 164°C, 165°C, 166°C, 175°C, 177°C, 186°C, 189°C, or 190°C;
(4) the cycloolefin resin material has a heat deflection temperature of ≥ 110°C, for example, 115°C, 117°C, 119°C, 122°C, 126°C, 127°C, 134°C, 137°C, 142°C, 144°C, 147°C, 158°C, or 167°C;
(5) the cycloolefin resin material is prepared using a liquid molding process, such as a reaction injection molding process, a resin transfer molding process, and a vacuum-assisted resin infusion process, wherein in the reaction injection molding process, the resin transfer molding process, and the vacuum-assisted resin infusion process, the temperature for molding may be 40-145°C, preferably 40-90°C, for example, 40°C, 45°C, 60°C, 70°C, 80°C, or 140°C; and the time for curing and molding may be 1-120 min, preferably 2-60 min, for example, 3.5 min, 5 min, 10 min, 20 min, 25 min, or 30 min.

10. A preparation method for a cycloolefin resin material, comprising the following steps: using the cycloolefin resin composition M1, the cycloolefin resin composition M2, the cycloolefin resin composition M3, the cycloolefin resin composition M4, or the cycloolefin resin composition M5 according to claim 8 as a raw material, mixing each component in the resin composition, curing, and molding via a liquid molding process to prepare the cycloolefin resin material, wherein the temperature for the curing and molding is 40-145°C, and the time for the curing and molding is 1-120 min;
preferably, the temperature for the curing and molding is 40°C, 45°C, 60°C, 70°C, 80°C, or 140°C;
preferably, the time for the curing and molding is 2-60 min, for example, 3-30 min, further for example, 3.5 min, 5 min, 10 min, 20 min, 25 min, or 30 min;
preferably, the liquid molding process is a reaction injection molding process, a resin transfer molding process, or a vacuum-assisted resin infusion process;
more preferably, the preparation method satisfies any one of the following conditions:
(1) the liquid molding process is a resin transfer molding process, comprising the following steps: adding a mixture of each component in the cycloolefin resin composition M1, M2, M3, M4, or M5 into a mold, curing and molding;
(2) the liquid molding process is a reaction injection molding process, wherein the raw material is the cycloolefin resin composition M3, comprising the following steps: adding a mixture of each component in the cycloolefin resin composition M3 into a mold, curing and molding;
preferably, the mixture of each component in the cycloolefin resin composition M3 is obtained by mixing each component of the cycloolefin resin composition M3 at 1-3 MPa, for example, 2 MPa;
preferably, the mixture of each component in the cycloolefin resin composition M3 is added into the mold within 4-6 s, for example, 5 s;
(3) the liquid molding process is a vacuum-assisted resin infusion process, comprising the following steps: adding a mixture of each component in the cycloolefin resin composition M1, M2, M3, M4, or M5 into a mold, curing and molding.

11. The preparation method for the cycloolefin resin material according to claim 10, wherein the preparation method satisfies one or more of the following conditions:
(1) in the reaction injection molding process, the resin transfer molding process, or the vacuum-assisted resin infusion process, the mixture is a mixture of component A in each resin composition and other components in each resin composition, wherein the component A may be treated as follows: stirring at 60°C-125°C for 4-12 hours, and cooling to room temperature for later use;
(2) in the reaction injection molding process, the resin transfer molding process, or the vacuum-assisted resin infusion process, the temperature of the mold is 40-145°C;
preferably, in the reaction injection molding process or the resin transfer molding process, the temperature on one side of the mold is 40-145°C, for example, 60-140°C; the temperature on the other side of the mold is 40-145°C, for example, 40-140°C;
more preferably, in the reaction injection molding RIM process or the resin transfer molding RTM process, the temperature of the mold is any one of the following schemes:
Scheme 1: the temperature on one side of the mold is 70°C, and the temperature on the other side of the mold is 40°C;
Scheme 2: the temperature on one side of the mold is 80°C, and the temperature on the other side of the mold is 45°C;
Scheme 3: the temperature on one side of the mold is 140°C, and the temperature on the other side of the mold is 140°C;
Scheme 4: the temperature on one side of the mold is 60°C, and the temperature on the other side of the mold is 40°C;
(3) the reaction injection molding process, the resin transfer molding process, or the vacuum-assisted resin infusion process further comprises a post-curing stage, wherein the temperature during the post-curing is 60-145°C, for example, 140°C, and the time for the post-curing is 0-60 min, for example, 20 min.

12. A method for reducing a dielectric constant and/or dielectric loss of a cycloolefin resin material, comprising: introducing the component B according to any one of claims 1-4 into the component A according to any one of claims 1-4 when preparing the cycloolefin resin material, wherein the molar ratio of Ru in the component B to the monomer of cycloolefin in the component A is 1:(7500-60000);
preferably, the raw material of the cycloolefin resin material is the cycloolefin resin composition M1, M2, M3, M4, or M5 according to claim 8;
preferably, a preparation method for the cycloolefin resin material is as described in the preparation method for the cycloolefin resin material according to any one of claims 10-11;
preferably, the molar ratio of Ru in the component B to the monomer of cycloolefin in the component A is 1:(7500-50000), for example, 1:7500, 1:9500, 1:10000, 1:15000, or 1:50000.

13. A prepreg comprising the cycloolefin resin material according to claim 9.

14. A copper-clad laminate comprising the prepreg according to claim 13.

15. A printed circuit board comprising the copper-clad laminate according to claim 14.
